(19) Europäisches Patentamt
European Patent Office
Office européen des brevets

(11) EP 3 054 745 A1

(12) EUROPEAN PATENT APPLICATION
published in accordance with Art. 153(4) EPC

(43) Date of publication:
**10.08.2016 Bulletin 2016/32**

(21) Application number: **14851161.1**

(22) Date of filing: **19.09.2014**

(51) Int Cl.:
***H05B 33/10*** (2006.01) ***C08G 61/12*** (2006.01)
***H01L 51/50*** (2006.01) ***H05B 33/04*** (2006.01)

(86) International application number:
**PCT/JP2014/075765**

(87) International publication number:
**WO 2015/050067 (09.04.2015 Gazette 2015/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **01.10.2013 JP 2013206140**

(71) Applicant: **Sumitomo Chemical Company Limited**
**Tokyo 104-8260 (JP)**

(72) Inventors:
- **ASADA, Kohei**
  **Tsukuba-shi**
  **Ibaraki 300-3294 (JP)**
- **TANAKA, Shin-ya**
  **Tsukuba-shi**
  **Ibaraki 300-3294 (JP)**
- **HAYASHI, Naoki**
  **Tsukuba-shi**
  **Ibaraki 300-3294 (JP)**

(74) Representative: **Newman, Alastair James Morley**
**J A Kemp**
**14 South Square**
**Gray's Inn**
**London WC1R 5JJ (GB)**

(54) **LIGHT EMITTING ELEMENT**

(57) A light emitting device comprising
an anode,
a cathode,
a light emitting layer disposed between the anode and the cathode and
an encapsulating layer,
wherein the temperature TA (°C) at which an annealing treatment is conducted after the formation of the encapsulating layer and the glass transition temperature TG (°C) of the material having the lowest glass transition temperature out of all materials each contained in an amount of 1 wt% or more in the light emitting layer satisfy the following formula (1), and

the current density IA at a voltage of 5 V applied before the annealing treatment and the current density IB at a voltage of 5 V applied after the annealing treatment satisfy the following formula (2):

$$TA < TG \quad (1)$$

$$0.50 \times IA \leqq IB \leqq 0.95 \times IA \quad (2).$$

EP 3 054 745 A1

**Description**

Technical Field

The present invention relates to an annealed light emitting device.

Background Art

An organic electroluminescent device (hereinafter, referred to also as "light emitting device") can be suitably used for application of displays because of high light emission efficiency and low driving voltage, and there are active research and development on the device. This light emitting device comprises organic layers such as a light emitting layer and a charge transporting layer. A low molecular weight compound is used in some cases or a polymer compound is used in some cases for formation of an organic layer, and the organic layer can be formed by coating methods typified by an inkjet printing method by use of a polymer compound, therefore, polymer compounds used for production of a light emitting device are investigated. Further, there is recently an investigation also on low molecular weight compounds soluble in an organic solvent which is used in production of a light emitting device.

A light emitting device is known to show a decrease in light emission efficiency and a decrease in light emission luminance with passage of driving time of current driving, and generates a problem that light emission efficiency in the initial period of driving of current driving lowers significantly and light emission luminance lowers steeply (that is, the luminance life in the initial period of driving is short). For this problem, Patent document 1 suggests that, after formation of a light emitting layer comprising a phosphorescence emitting compound and before vapor deposition of a cathode, the formed light emitting layer is annealed to improve the luminance life in the initial period of driving.

Prior Art Document

Patent Document

Patent document 1: US Patent Application Publication No. 2006/0040136

Summary of the Invention

Problem to be Solved by the Invention

A light emitting device produced by the above-described method, however, had not necessarily sufficient luminance life in the initial period of driving.

Then, the present invention has an object of providing a light emitting device excellent in the luminance life in the initial period of driving.

Means for Solving the Problem

The present invention provides a light emitting device comprising
an anode,
a cathode,
a light emitting layer disposed between the anode and the cathode and
an encapsulating layer,
wherein the temperature TA (°C) at which an annealing treatment is conducted after the formation of the encapsulating layer and the glass transition temperature TG (°C) of the material having the lowest glass transition temperature out of all materials each contained in an amount of 1 wt% or more in the light emitting layer satisfy the following formula (1), and the current density IA at a voltage of 5 V applied before the annealing treatment and the current density IB at a voltage of 5 V applied after the annealing treatment satisfy the following formula (2):

$$TA < TG \quad (1)$$

$$0.50 \times IA \leqq IB \leqq 0.95 \times IA \quad (2).$$

Effect of the Invention

The present invention can provide a light emitting device excellent in the luminance life in the initial period of driving.

Modes for Carrying Out the Invention

Suitable embodiments of the present invention will be illustrated in detail below.

<Explanation of common term>

Terms commonly used in the present specification described below have the following meanings unless otherwise stated.
Me represents a methyl group, Et represents an ethyl group, i-Pr represents an isopropyl group, n-Bu represents a n-butyl group, and t-Bu represents a tert-butyl group.
In the present specification, the hydrogen atom may be a light hydrogen atom or a heavy hydrogen atom.
"Polymer compound" denotes a polymer having molecular weight distribution and having a polystyrene-equivalent number average molecular weight of $1\times10^3$ to $1\times10^8$. The total amount of constitutional units contained in the polymer compound is 100 mol%.
A polymer compound may be any of a block copolymer, a random copolymer, an alternate copolymer and a graft copolymer, and may also be another form.
An end group of a polymer compound is preferably a stable group because if a polymerization active group remains intact at the end, when the polymer compound is used for fabrication of a light emitting device, the light emitting property or luminance life in the initial period of driving possibly becomes lower. This end group is preferably a group having a conjugated bond to the main chain, and includes groups bonding to an aryl group or a monovalent heterocyclic group via a carbon-carbon bond.
"Low molecular weight compound" denotes a compound having no molecular weight distribution and having a molecular weight of $1\times10^4$ or less.
"Constitutional unit" denotes a unit structure found once or more in a polymer compound.
"Alkyl group" may be any of linear, branched or cyclic. The number of carbon atoms of the linear alkyl group is, not including the number of carbon atoms of a substituent, usually 1 to 50, preferably 3 to 30, more preferably 4 to 20. The number of carbon atoms of the branched or cyclic alkyl groups is, not including the number of carbon atoms of a substituent, usually 3 to 50, preferably 3 to 30, more preferably 4 to 20.
The alkyl group optionally has a substituent, and examples thereof include a non-substituted alkyl group such as a methyl group, an ethyl group, a n-propyl group, an isopropyl group, a n-butyl group, an isobutyl group, a tert-butyl group, a n-pentyl group, an isoamyl group, 2-ethylbutyl group, a n-hexyl group, a cyclohexyl group, a n-heptyl group, a cyclohexylmethyl group, a cyclohexylethyl group, a n-octyl group, a 2-ethylhexyl group, a 3-n-propylheptyl group, a n-decyl group, a 3,7-dimethyloctyl group, a 2-ethyloctyl group, a 2-n-hexyldecyl group and a n-dodecyl group; and a substituted alkyl group such as a trifluoromethyl group, a pentafluoroethyl group, a perfluorobutyl group, a perfluorohexyl group, a perfluorooctyl group, a 3-phenylpropyl group, a 3-(4-methylphenyl)propyl group, a 3-(3,5-di-n-hexylphenyl) propyl group and a 6-ethyloxyhexyl group.
"Aryl group" denotes an atomic group remaining after removing from an aromatic hydrocarbon one hydrogen atom linked directly to a carbon atom constituting the ring. The number of carbon atoms of the aryl group is, not including the number of carbon atoms of a substituent, usually 6 to 60, preferably 6 to 20, more preferably 6 to 10.
The aryl group optionally has a substituent, and examples thereof include a phenyl group, a 1-naphthyl group, a 2-naphthyl group, a 1-anthracenyl group, a 2-anthracenyl group, a 9-anthracenyl group, a 1-pyrenyl group, a 2-pyrenyl group, a 4-pyrenyl group, a 2-fluorenyl group, a 3-fluorenyl group, a 4-fluorenyl group, a 2-phenylphenyl group, a 3-phenylphenyl group, a 4-phenylphenyl group, and groups obtained by substituting a hydrogen atom in these groups with an alkyl group, an alkoxy group, an aryl group, a fluorine atom or the like.
"Alkoxy group" may be any of linear, branched or cyclic. The number of carbon atoms of the linear alkoxy group is, not including the number of carbon atoms of a substituent, usually 1 to 40, preferably 4 to 10. The number of carbon atoms of the branched or cyclic alkoxy groups is, not including the number of carbon atoms of a substituent, usually 3 to 40, preferably 4 to 10.
The alkoxy group optionally has a substituent, and examples thereof include a methoxy group, an ethoxy group, a n-propyloxy group, an isopropyloxy group, a n-butyloxy group, an isobutyloxy group, a tert-butyloxy group, a n-pentyloxy group, a n-hexyloxy group, a cyclohexyloxy group, a n-heptyloxy group, a n-octyloxy group, a 2-ethylhexyloxy group, a n-nonyloxy group, a n-decyloxy group, a 3, 7-dimethyloctyloxy group and a lauryloxy group.
The number of carbon atoms of "Aryloxy group" is, not including the number of carbon atoms of a substituent,

usually 6 to 60, preferably 7 to 48.

The aryloxy group optionally has a substituent, and examples thereof include a phenoxy group, a 1-naphthyloxy group, a 2-naphthyloxy group, a 1-anthracenyloxy group, a 9-anthracenyloxy group, a 1-pyrenyloxy group, and groups obtained by substituting a hydrogen atom in these groups with an alkyl group, an alkoxy group, a fluorine atom or the like.

"p-Valent heterocyclic group" (p represents an integer of 1 or more) denotes an atomic group remaining after removing from a heterocyclic compound p hydrogen atoms among hydrogen atoms directly linked to a carbon atom or a hetero atom constituting the ring. Of p-valent heterocyclic groups, "p-valent aromatic heterocyclic groups" as an atomic group remaining after removing from an aromatic heterocyclic compound p hydrogen atoms among hydrogen atoms directly linked to a carbon atom or a hetero atom constituting the ring are preferable.

"Aromatic heterocyclic compound" denotes a compound in which the heterocyclic ring itself shows aromaticity such as oxadiazole, thiadiazole, thiazole, oxazole, thiophene, pyrrole, phosphole, furan, pyridine, pyrazine, pyrimidine, triazine, pyridazine, quinoline, isoquinoline, carbazole and dibenzophosphole, and a compound in which an aromatic ring is condensed to the heterocyclic ring even if the heterocyclic ring itself shows no aromaticity such as phenoxazine, phenothiazine, dibenzoborole, dibenzosilole and benzopyran.

The number of carbon atoms of the monovalent heterocyclic group is, not including the number of carbon atoms of a substituent, usually 2 to 60, preferably 4 to 20.

The monovalent heterocyclic group optionally has a substituent, and examples thereof include a thienyl group, a pyrrolyl group, a furyl group, a pyridyl group, a piperidyl group, a quinolyl group, an isoquinolyl group, a pyrimidyl group, a triazinyl group, and groups obtained by substituting a hydrogen atom in these groups with an alkyl group, an alkoxy group or the like.

"Halogen atom" denotes a fluorine atom, a chlorine atom, a bromine atom or an iodine atom.

"Amino group" optionally has a substituent, and a substituted amino group is preferable. The substituent which an amino group has is preferably an alkyl group, an aryl group or a monovalent heterocyclic group.

The substituted amino group includes, for example, a dialkylamino group and a diarylamino group.

The amino group includes, for example, a dimethylamino group, a diethylamino group, a diphenylamino group, a bis(4-methylphenyl)amino group, a bis(4-tert-butylphenyl)amino group and a bis(3,5-di-tert-butylphenyl)amino group.

"Alkenyl group" may be any of linear, branched or cyclic. The number of carbon atoms of the linear alkenyl group, not including the number of carbon atoms of the substituent, is usually 2 to 30, preferably 3 to 20. The number of carbon atoms of the branched or cyclic alkenyl group, not including the number of carbon atoms of the substituent, is usually 3 to 30, preferably 4 to 20.

The alkenyl group optionally has a substituent, and examples thereof include a vinyl group, a 1-propenyl group, a 2-propenyl group, a 2-butenyl group, a 3-butenyl group, a 3-pentenyl group, a 4-pentenyl group, a 1-hexenyl group, a 5-hexenyl group, a 7-octenyl group, and these groups having a substituent.

"Alkynyl group" may be any of linear, branched or cyclic. The number of carbon atoms of the alkynyl group, not including the number of carbon atoms of the substituent, is usually 2 to 20, preferably 3 to 20. The number of carbon atoms of the branched or cyclic alkynyl, not including the number of carbon atoms of the substituent, is usually 4 to 30, preferably 4 to 20.

The alkynyl group optionally has a substituent, and examples thereof include an ethynyl group, a 1-propynyl group, a 2-propynyl group, a 2-butynyl group, a 3-butynyl group, a 3-pentynyl group, a 4-pentynyl group, a 1-hexenyl group, a 5-hexenyl group, and these groups having a substituent.

"Arylene group" denotes an atomic group remaining after removing from an aromatic hydrocarbon two hydrogen atoms linked directly to carbon atoms constituting the ring. The number of carbon atoms of the arylene group is, not including the number of carbon atoms of a substituent, usually 6 to 60, preferably 6 to 30, more preferably 6 to 18.

The arylene group optionally has a substituent, and examples thereof include a phenylene group, a naphthalenediyl group, an anthracenediyl group, a phenanthrenediyl group, a dihydrophenanthrenediyl group, a naphthacenediyl group, a fluorenediyl group, a pyrenediyl group, a perylenediyl group, a chrysenediyl group, and these groups having a substituent, preferably, groups represented by the formulae (A-1) to (A-20). The arylene group includes groups obtained by linking a plurality of these groups.

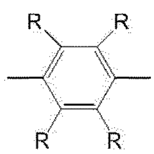
(A-1)

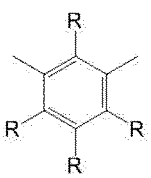
(A-2)

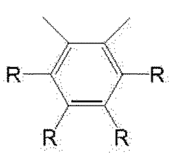
(A-3)

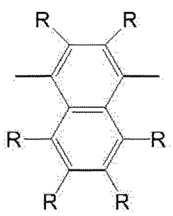
(A-4)

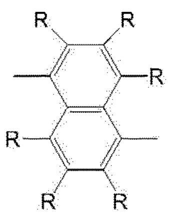
(A-5)

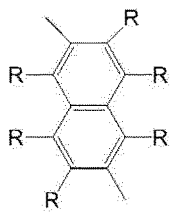
(A-6)

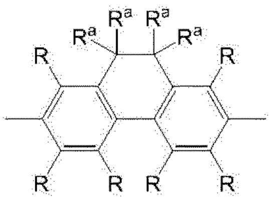
(A-7)

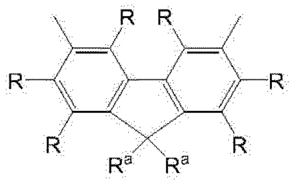
(A-8)

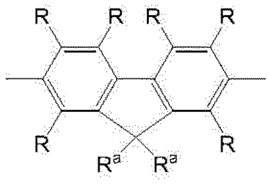
(A-9)

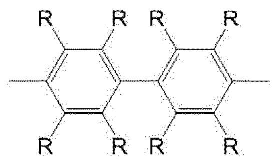
(A-10)

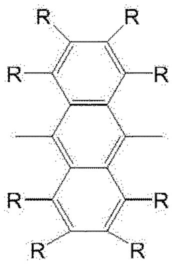
(A-11)

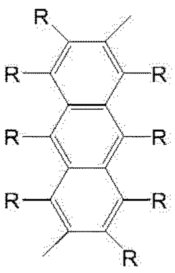
(A-12)

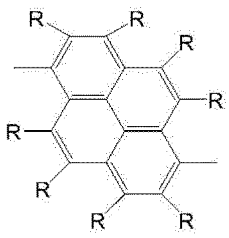
(A-13)

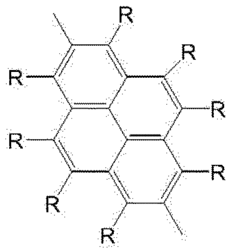
(A-14)

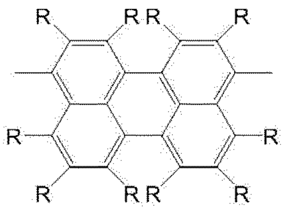
(A-15)

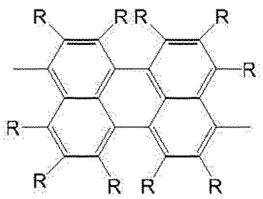
(A-16)

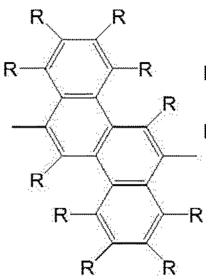
(A-17)

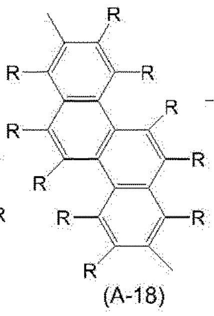
(A-18)

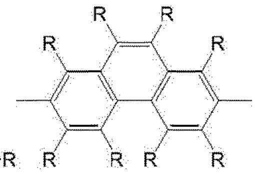
(A-19)

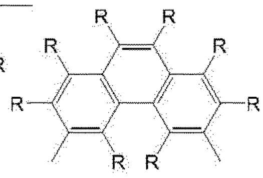
(A-20)

[wherein, R and $R^a$ each independently represent a hydrogen atom, an alkyl group, an aryl group or a monovalent heterocyclic group. The Rs and $R^a$ s each may be the same or different, and adjacent $R^a$ s may be combined together to form a ring together with the atoms to which they are attached.]

The number of carbon atoms of the divalent heterocyclic group is, not including the number of carbon atoms of a substituent, usually 2 to 60, preferably 3 to 30, more preferably 4 to 15.

The divalent heterocyclic group optionally has a substituent, and examples thereof include divalent groups obtained by removing from pyridine, diazabenzene, triazine, azanaphthalene, diazanaphthalene, carbazole, dibenzofuran, dibenzothiophene, dibenzosilole, phenoxazine, phenothiazine, acridine, dihydroacridine, furan, thiophene, azole, diazole and triazole two hydrogen atoms among hydrogen atoms linking directly to a carbon atom or a hetero atom constituting the ring, preferably groups represented by the formulae (A-21) to (A-54). The divalent heterocyclic group includes groups obtained by linking a plurality of these groups.

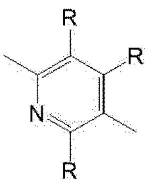
(A-21)

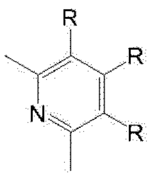
(A-22)

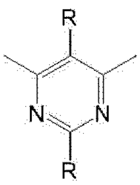
(A-23)

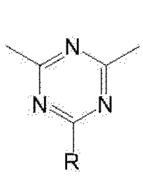
(A-24)

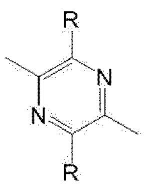
(A-25)

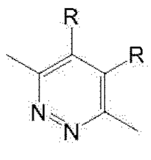
(A-26)

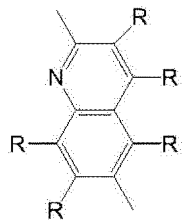
(A-27)

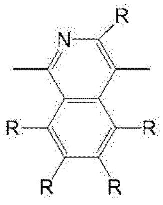
(A-28)

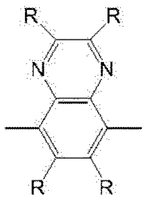
(A-29)

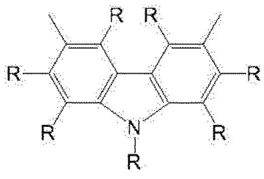
(A-30)

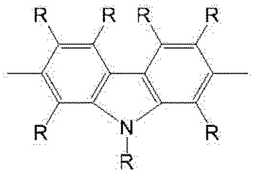
(A-31)

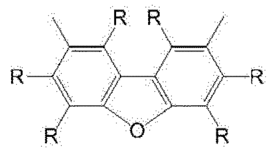
(A-32)

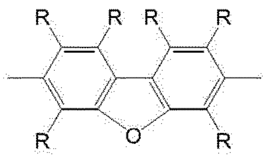
(A-33)

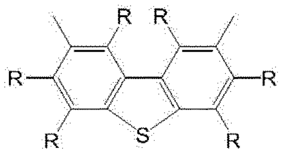
(A-34)

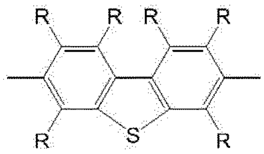
(A-35)

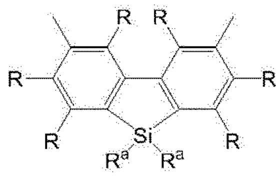
(A-36)

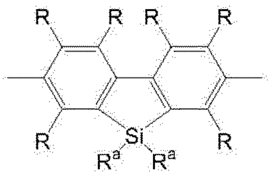
(A-37)

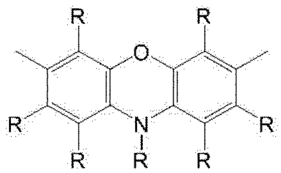
(A-38)

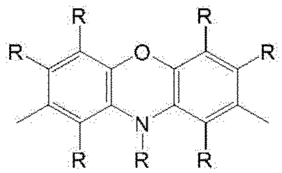
(A-39)

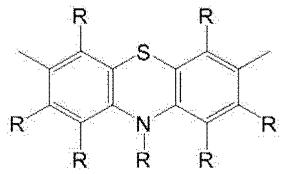
(A-40)

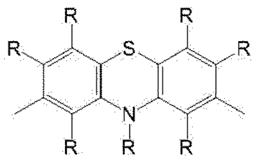
(A-41)

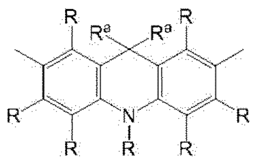
(A-42)

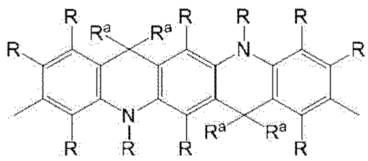
(A-43)

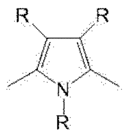
(A-44)

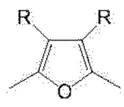
(A-45)

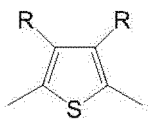
(A-46)

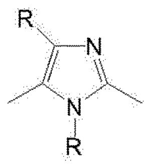
(A-47)

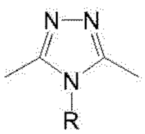
(A-48)

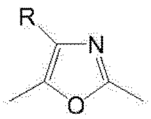
(A-49)

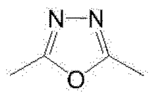
(A-50)

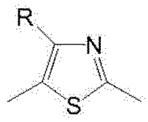
(A-51)

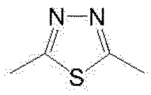
(A-52)

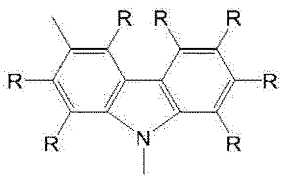
(A-53)

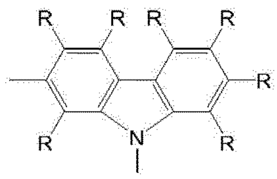
(A-54)

[wherein, R and $R^a$ represent the same meaning as described above.]

"Cross-linkable group" is a group capable of generating a new linkage by subjecting to a heating treatment, a light irradiation treatment (for example, ultraviolet irradiation treatment), a radical reaction and the like, and is preferably a group represented by the formula (B-1), (B-2), (B-3), (B-4), (B-5), (B-6), (B-7), (B-8), (B-9), (B-10), (B-11), (B-12), (B-13), (B-14), (B-15), (B-16) or (B-17).

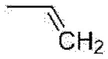
(B-1)
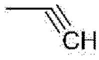
(B-2)
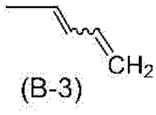
(B-3)
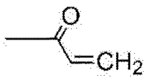
(B-4)
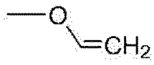
(B-5)
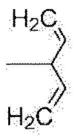
(B-6)
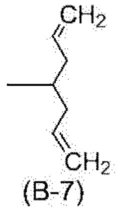
(B-7)
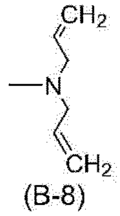
(B-8)

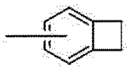
(B-9)
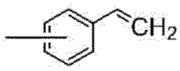
(B-10)
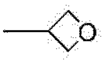
(B-11)
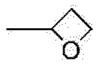
(B-12)
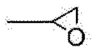
(B-13)
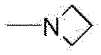
(B-14)
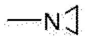
(B-15)
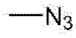
(B-16)
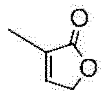
(B-17)

[wherein, these groups each optionally have a substituent.]

"Substituent" represents a halogen atom, a cyano group, an alkyl group, an aryl group, a monovalent heterocyclic group, an alkoxy group, an aryloxy group, an amino group, a substituted amino group, an alkenyl group or an alkynyl group. The substutuent may be a crosslinkable group.

<Light emitting device>

The light emitting device of the present invention is a light emitting device comprising an anode, a cathode, a light emitting layer disposed between the anode and the cathode and an encapsulating layer, wherein the temperature TA (°C) at which an annealing treatment is conducted after the formation of the encapsulating layer and the glass transition temperature TG (°C) of the material having the lowest glass transition temperature out of all materials each contained in an amount of 1 wt% or more in the light emitting layer satisfy the above-described formula (1), and the current density IA at a voltage of 5 V applied before the annealing treatment and the current density IB at a voltage of 5 V applied after the annealing treatment satisfy the above-described formula (2).

The voltage of 5 V applied corresponds to the voltage actually applicable in driving a light emitting device.

The material having the lowest glass transition temperature contained in an amount of 1 wt% or more in a light emitting layer is preferably contained in an amount of 3 wt% or more in a light emitting layer, more preferably contained in an amount of 5 wt% or more in a light emitting layer.

TA and TG preferably satisfy the following formula (3), more preferably satisfy the following formula (3'), further preferably satisfy the following formula (3"), because the light emission efficiency of the light emitting device of the present invention is excellent.

$$TA < TG-30 \qquad (3)$$

$$TA < TG-40 \qquad (3')$$

$$TA < TG-50 \qquad (3'')$$

TA is preferably 50°C or higher (for example, 50°C to 80°C), more preferably 60°C or higher (for example, 60°C to 80°C), further preferably 60°C to 70°C, because the light emission efficiency of the light emitting device of the present invention is excellent.

TG is preferably 90°C to 250°C, more preferably 95°C to 200°C, further preferably 100°C to 180°C, because the luminance life of the light emitting device of the present invention is excellent.

IA and IB preferably satisfy the following formula (4), more preferably satisfy the following formula (5), further preferably satisfy the following formula (6), because the light emission efficiency of the light emitting device of the present invention is excellent.

$$0.70 \times IA \leqq IB \leqq 0.90 \times IA \qquad (4)$$

$$0.70 \times IA \leqq IB \leqq 0.85 \times IA \quad (5)$$

$$0.75 \times IA \leqq IB \leqq 0.85 \times IA \quad (6)$$

[Annealing treatment]

The annealing treatment method includes, for example, annealing using an oven, annealing using a hot plate, annealing using infrared and annealing using visible light, preferably annealing using an oven or annealing using a hot plate.

The environment for conducting the annealing treatment may be under an atmospheric gas atmosphere or under an inert gas atmosphere. The inert gas atmosphere includes, for example, a nitrogen gas atmosphere and an argon gas atmosphere.

Though the time of the annealing treatment is not restricted, it is preferably 1 minute to 150 hours, more preferably 10 minutes to 50 hours, further preferably 15 minutes to 40 hours, because the luminance life of the light emitting device of the present invention is excellent.

[Layer constitution]

The light emitting device of the present invention may have layers other than an anode, a cathode, a light emitting layer and an encapsulating layer (hereinafter, referred to also as "other layer"). The other layer includes, for example, a hole transporting layer, a hole injection layer, an electron transporting layer and an electron injection layer. The light emitting layer, the hole transporting layer, the hole injection layer, the electron transporting layer and the electron injection layer comprise a light emitting material, a hole transporting material, a hole injection material, an electron transporting material and an electron injection material, respectively, and can be formed using a light emitting material, a hole transporting material, a hole injection material, an electron transporting material and an electron injection material, respectively.

The materials of the light emitting layer, the hole transporting layer, the hole injection layer, the electron transporting layer and the electron injection layer include light emitting materials, hole transporting materials, hole injection materials, electron transporting materials and electron injection materials described later.

The order, number and thickness of layers to be laminated may advantageously be adjusted in view of the light emission efficiency and driving voltage of the light emitting device.

The thicknesses of the light emitting layer, the hole transporting layer, the hole injection layer, the electron transporting layer and the electron injection layer are usually 1 nm to 10 μm.

The light emitting device of the present invention preferably has at least one of a hole injection layer and a hole transporting layer between an anode and a light emitting layer from the standpoint of hole injectability and hole transportability, and preferably has at least one of an electron injection layer and an electron transporting layer between a cathode and a light emitting layer from the standpoint of electron injectability and electron transportability.

The methods of forming the light emitting layer, the hole transporting layer, the hole injection layer, the electron transporting layer and the electron injection layer in the light emitting device of the present invention include, for example, a vacuum vapor deposition method from a powder and a method of film formation from a solution or melted state when a low molecular weight compound is used, and include, for example, a method of film formation from a solution or melted state when a polymer compound is used.

The light emitting layer, the hole transporting layer, the hole injection layer, the electron transporting layer and the electron injection layer can be fabricated by, for example, a spin coat method, a casting method, a micro gravure coat method, a gravure coat method, a bar coat method, a roll coat method, a wire bar coat method, a dip coat method, a spray coat method, a screen printing method, a flexo printing method, an offset printing method, an inkjet printing method, a capillary coat method and a nozzle coat method using inks comprising a light emitting material, a hole transporting material, a hole injection material, an electron transporting material and an electron injection material (that is, compositions comprising these materials and a solvent), respectively.

The viscosity of the ink may be adjusted depending on the kind of the printing method, and when a solution goes through a discharge apparatus such as in an inkjet printing method, the viscosity is preferably in the range of 1 to 20 mPa·s at 25°C for preventing curved aviation and clogging in discharging.

As the solvent contained in the ink, those capable of dissolving or uniformly dispersing solid components in the ink are preferable. The solvent includes, for example, chlorine-based solvents such as 1,2-dichloroethane, 1,1,2-trichloroethane, chlorobenzene and o-dichlorobenzene; ether solvents such as tetrahydrofuran, dioxane, anisole and 4-methylanisole; aromatic hydrocarbon solvents such as toluene, xylene, mesitylene, ethylbenzene, n-hexylbenzene and cyclohexylbenzene; aliphatic hydrocarbon solvents such as cyclohexane, methylcyclohexane, n-pentane, n-hexane, n-heptane, n-octane, n-nonane, n-decane, n-decane and bicyclohexyl; ketone solvents such as acetone, methylethylketone, cyclohexanone, benzophenone and acetophenone; ester solvents such as ethyl acetate, butyl acetate, ethylcellosolve acetate, methyl benzoate and phenyl acetate; poly-hydric alcohols such as ethylene glycol, glycerin and 1,2-hexanediol and derivatives thereof; alcohol solvents such as isopropanol and cyclohexanol; sulfoxide solvents such as dimethyl sulfoxide; and amide solvents such as N-methyl-2-pyrrolidone and N,N-dimethylformamide. These solvents may be used singly or two or more of them may be used in combination.

In the ink, the compounding amount of the above-described solvent is usually 1000 to 100000 parts by weight, preferably 2000 to 20000 parts by weight with respect to 100 parts by weight of the light emitting material, a hole transporting material, a hole injection material, an electron transporting material or an electron injection material.

When the material of a hole transporting layer, the material of an electron transporting layer and the material of a light emitting layer are soluble in a solvent which is used in forming a layer adjacent to the hole transporting layer, the electron transporting layer and the light emitting layer, respectively, in fabrication of a light emitting device, it is preferable that the materials have a crosslinkable group to avoid dissolution of the materials in the solvent. After forming the layers using the materials having a crosslinkable group, the layers can be insolubilized by crosslinking the crosslinkable group.

The temperature of heating for crosslinking each layer is usually 25 to 300°C, and it is preferably 50 to 250°C, more preferably 150 to 200°C, because the luminance life in the initial period of driving of the light emitting device of the present invention is excellent.

The kind of light used for irradiation for crosslinking each layer is, for example, ultraviolet light, near ultraviolet light or visible light.

[Encapsulating layer]

The encapsulating layer is not restricted providing it has a barrier property against moisture and an oxygen gas, and in one embodiment of the encapsulating layer, an anode, a cathode, a light emitting layer and other layers which a light emitting device has are hermetically encapsulated by a substrate made of a material such as glass, plastic and silicon under condition of filling of an inert gas such as a nitrogen gas, an argon gas and the like. In another embodiment of the encapsulating layer, an anode, a cathode, a light emitting layer and other layers which a light emitting device has are hermetically encapsulated by a substrate made of a material such as glass, plastic and silicon via an insulation layer made of an organic substance or an insulation layer made of an inorganic substance. The material of the insulation layer made of an organic substance includes, for example, thermoplastic resins and photocrosslinkable resins. The material of the insulation layer made of an inorganic substance includes, for example, metal oxides and metal nitrides.

Since the light emitting device of the present invention has undergone an annealing treatment after formation of an encapsulating layer, it is preferable that a desiccant is contained in the encapsulating layer. The desiccant may be disposed on the encapsulating layer.

[Substrate/electrode]

The light emitting device of the present invention usually has a substrate. The substrate which the light emitting device of the present invention has may advantageously be one capable of forming an electrode and not chemically changing in forming an organic layer, and is, for example, a substrate made of a material such as glass, plastic and silicon. In the case of an opaque substrate, it is preferable that the uttermost electrode from the substrate is transparent or semitransparent.

The material of the anode includes, for example, electrically conductive metal oxides and semi-transparent metals, preferably, indium oxide, zinc oxide and tin oxide; electrically conductive compounds such as indium·tin·oxide (ITO) and indium·zinc·oxide; a composite of silver, palladium and copper (APC); NESA, gold, platinum, silver and copper.

The material of the cathode includes, for example, metals such as lithium, sodium, potassium, rubidium, cesium, beryllium, magnesium, calcium, strontium, barium, aluminum, zinc and indium; alloys composed of two or more of them; alloys composed of one or more of them and at least one of silver, copper, manganese, titanium, cobalt, nickel, tungsten and tin; and graphite and graphite intercalation compounds. The alloy includes, for example, a magnesium-silver alloy, a magnesium-indium alloy, a magnesium-aluminum alloy, an indium-silver alloy, a lithium-aluminum alloy, a lithium-magnesium alloy, a lithium-indium alloy and a calcium-aluminum alloy.

The anode and the cathode may each take a lamination structure composed of two or more layers.

[Light emitting material]

The light emitting material is classified into low molecular weight compounds and polymer compounds. The light emitting material may have a crosslinkable group.
The low molecular weight compound includes, for example, naphthalene and derivatives thereof, anthracene and derivatives thereof, perylene and derivatives thereof, and, triplet light emitting complexes having iridium, platinum or europium as the center metal.
The polymer compound includes, for example, polymer compounds comprising a phenylene group, a naphthalenediyl group, a fluorenediyldiyl group, a phenanthrenediyl group, a dihydrophenanthrenediyl group, a group represented by the formula (X) described later, a carbazolediyl group, a phenoxazinediyl group, a phenothiazinediyl group, an anthracenediyl group, a pyrenediyl group and the like.
The light emitting material may comprise a compound of low molecular weight and a polymer compound, and preferably, comprises a triplet light emitting complex and a polymer compound.

[Hole transporting material]

The hole transporting material is classified into low molecular weight compounds and polymer compounds, and polymer compounds are preferable, polymer compounds having a crosslinkable group are more preferable.
The polymer compound includes, for example, polyvinylcarbazole and derivatives thereof; polyarylene having an aromatic amine structure in the side chain or main chain and derivatives thereof. The polymer compound may also be a compound in which an electron accepting portion is linked. The electron accepting portion includes, for example, fullerene, tetrafluorotetracyanoquinodimethane, tetracyanoethylene and trinitrofluorenone, preferably fullerene.
The hole transporting material may be used singly or two or more hole transporting materials may be used in combination.

[Electron transporting material]

The electron transporting material is classified into low molecular weight compounds and polymer compounds. The electron transporting material may have a crosslinkable group.
The low molecular weight compound includes, for example, a metal complexe having 8-hydroxyquinoline as a ligand, oxadiazole, anthraquinodimethane, benzoquinone, naphthoquinone, anthraquinone, tetracyanoanthraquinodimethane, fluorenone, diphenyldicyanoethylene, diphenoquinone and derivatives thereof.
The polymer compound includes, for example, polyphenylene, polyfluorene and derivatives thereof. These polymer compounds may be doped with a metal.
The electron transporting material may be used singly or two or more electron transporting materials may be used in combination.

[Hole injection material and electron injection material]

The hole injection material and the electron injection material are each classified into low molecular weight compounds and polymer compounds. The hole injection material and the electron injection material may have a crosslinkable group.
The low molecular weight compound includes, for example, metal phthalocyanines such as copper phthalocyanine; carbon; oxides of metals such as molybdenum and tungsten; metal fluorides such as lithium fluoride, sodium fluoride, cesium fluoride and potassium fluoride.
The polymer compound includes, for example, polyaniline, polythiophene, polypyrrole, polyphenylenevinylene, polythienylenevinylene, polyquinoline and polyquinoxaline, and derivatives thereof; electrically conductive polymers such as a polymer comprising a group represented by the formula (X) described later in the side chain or main chain.
The hole injection material and the electron injection material may each be used singly or two or more of them may be used in combination.

[Ion dope]

When the hole injection material or the electron injection material comprises an electrically conductive polymer, the electric conductivity of the electrically conductive polymer is preferably $1\times10^{-5}$ S/cm to $1\times10^{3}$ S/cm. For adjusting the electric conductivity of the electrically conductive polymer within such a range, the electrically conductive polymer can be doped with a suitable amount of ions.
The kind of the ion to be doped is an anion for a hole injection material and a cation for an electron injection

material. The anion includes, for example, a polystyrenesulfonate ion, an alkylbenzenesulfonate ion and a camphorsulfonate ion. The cation includes, for example, a lithium ion, a sodium ion, a potassium ion and a tetrabutylammonium ion.

The ion to be doped may be used singly or two or more ions to be doped may be used.

[Use]

For obtaining planar light emission using a light emitting device, it may be advantageous that a planar anode and a planar cathode are disposed so as to overlap. For obtaining light emission in the form of pattern, there are a method in which a mask having a window in the form of pattern is placed on the surface of a planer light emitting device, a method in which a layer intending a non-luminous part is formed extremely thickly to give substantially no emission, and a method in which an anode or a cathode or both electrodes are formed in the form of pattern. By forming a pattern by any of these methods and by disposing several electrodes so that independent ON/OFF is possible, a segment type display capable of displaying numbers and letters, simple marks and the like is obtained. For obtaining a dot matrix display, it may be advantageous that both an anode and a cathode are formed in the form of stripe and disposed so as to cross. Partial color display and multi-color display are made possible by a method in which several kinds of polymer compounds showing different emission colors are painted separately and a method of using a color filter or a fluorescence conversion filter. The dot matrix display can be passively driven, or actively driven combined with TFT and the like. These displays can be used in computers, television sets, portable terminals, cellular telephones, car navigations, video camera view finders and the like. The planar light emitting device is of self-emission and thin type, and can be suitably used as a planer light source for backlight of a liquid display, or as a planar light source for illumination. If a flexible substrate is used, it can be used also as a curved light source and a curved display.

[Material of light emitting layer]

The low molecular weight compound used for forming the light emitting layer in the light emitting device of the present invention includes, for example, compounds having a carbazole skeleton such as 4,4'-bis(carbazol-9-yl)biphenyl (CBP) and 1,3-bis(carbazol-9-yl)benzene (mcP); compounds having a triarylamine skeleton such as 1,1-bis[4-[N,N-di(p-tolyl)amino]phenyl]cyclohexane (TAPC), 4,4'-bis[N-(m-tolyl)-N-phenylamino]biphenyl (TPD) and N,N'-di(1-naphthyl)-N,N'-diphenylbenzidine (NPB); compounds having a phenanthroline skeleton such as 2,9-dimethyl-4,7-diphenyl-1,10-phenanthroline (BCP); compounds having a triaryltriazine skeleton such as triphenyltriazine; organosilicon compounds such as p-bis(triphenylsilyl)benzene (UGH2) and 4,4'-bis(triphenylsilyl)biphenyl (BSB); compounds having an azole skeleton such as 1,3,5-tris(N-phenylbenzoimidazol-2-yl)benzene (TPBI), 3-(biphenyl-4-yl)-5-(4-tert-butylphenyl)-4-phenyl-4H-1,2,4-triazole (t-Bu-TAZ) and 2-(biphenyl-4-yl)-5-(4-tert-butylphenyl)-1,3,4-oxadiazole (PBD); and compounds combining these skeletons. The compound combining the skeletons includes, for example, compounds having a carbazole skeleton and a triarylamine skeleton such as 4,4',4''-tris(carbazol-9-yl)triphenylamine (TCTA).

The low molecular weight compound used for forming the light emitting layer in the light emitting device of the present invention includes also compounds represented by the formula (H-1).

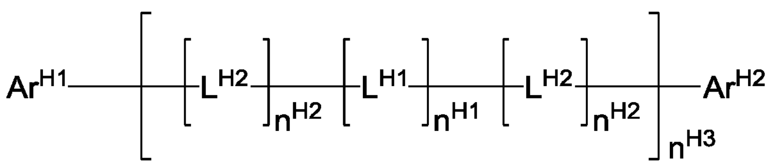

(H-1)

[wherein,

$Ar^{H1}$ and $Ar^{H2}$ each independently represent an aryl group or a monovalent heterocyclic group and these groups each optionally have a substituent.

$n^{H1}$ and $n^{H2}$ each independently represent 0 or 1. When there are a plurality of $n^{H1}$, they may be the same or different. The $n^{H2}$ s may be the same or different.

$n^{H3}$ represents an integer of 0 or more.

$L^{H1}$ represents an arylene group, a divalent heterocyclic group or a group represented by -[C($R^{H11}$)$_2$]$n^{H11}$-, and these groups each optionally have a substituent. When there are a plurality of $L^{H1}$, they may be the same or different.

$n^{H11}$ represents an integer of 1 or more and 10 or less. $R^{H11}$ represents a hydrogen atom, an alkyl group, a cycloalkyl group, an alkoxy group, a cycloalkoxy group, an aryl group or a monovalent heterocyclic group and these groups each optionally have a substituent. The $R^{H11}$s may be the same or different and may be combined together to form a ring together with the carbon atoms to which they are attached.

$L^{H2}$ represents a group represented by -N(-$L^{H21}$-$R^{H21}$)-. When there are a plurality of $L^{H2}$, they may be the

same or different.

$L^{H21}$ represents a single bond, an arylene group or a divalent heterocyclic group and these groups each optionally have a substituent. $R^{H21}$ represents a hydrogen atom, an alkyl group, a cycloalkyl group, an aryl group, a cycloalkoxy group or a monovalent heterocyclic group and these groups each optionally have a substituent.]

$Ar^{H1}$ and $Ar^{H2}$ are preferably a phenyl group, a fluorenyl group, a spirobifluorenyl group, a pyridyl group, a pyrimidinyl group, a triazinyl group, a quinolinyl group, an isoquinolinyl group, a thienyl group, a benzothienyl group, a dibenzothienyl group, a furyl group, a benzofuryl group, a dibenzofuryl group, a pyrrolyl group, an indolyl group, an azaindolyl group, a carbazolyl group, an azacarbazolyl group, a diazacarbazolyl group, a phenoxazinyl group or a phenothiazinyl group, more preferably a phenyl group, a spirobifluorenyl group, a pyridyl group, a pyrimidinyl group, a triazinyl group, a dibenzothienyl group, a dibenzofuryl group, a carbazolyl group or an azacarbazolyl group, further preferably a phenyl group, a pyridyl group, a carbazolyl group or an azacarbazolyl group, particularly preferably a group represented by the formula (TDA-1) or (TDA-3) described later, especially preferably a group represented by the formula (TDA-3) described later, and these groups each optionally have a substituent.

The substituent which $Ar^{H1}$ and $Ar^{H2}$ each optionally have is preferably a halogen atom, an alkyl group, a cycloalkyl group, an alkoxy group, a cycloalkoxy group, an aryl group or a monovalent heterocyclic group, more preferably an alkyl group, cycloalkyl group, an alkoxy group or cycloalkoxy group, further preferably an alkyl group or cycloalkyl group, and these groups optionally further have a substituent.

$n^{H1}$ is preferably 1. $n^{H2}$ is preferably 0.

$n^{H3}$ is usually an integer of 0 or more and 10 or less, preferably an integer of 0 or more and 5 or less, further preferably an integer of 1 or more and 3 or less, particularly preferably 1.

$n^{H11}$ is preferably an integer of 1 or more and 5 or less, more preferably an integer of 1 or more and 3 or less, further preferably 1.

$R^{H11}$ is preferably a hydrogen atom, an alkyl group, a cycloalkyl group, an aryl group, a cycloalkoxy group or a monovalent heterocyclic group, more preferably a hydrogen atom, an alkyl group or cycloalkyl group, and these groups each optionally have a substituent.

$L^{H1}$ is preferably an arylene group or a divalent heterocyclic group.

$L^{H1}$ is preferably a group represented by the formulae (A-1) to (A-3), the formulae (A-8) to (A-10), the formulae (A-21) to (A-26), the formulae (A-30) to (A-41) or the formulae (A-44) to (A-54), more preferably a group represented by the formula (A-1), the formula (A-2), the formula (A-8), the formula (A-9), the formulae (A-21) to (A-24), the formulae (A-30) to (A-35) or the formulae (A-49) to (A-54), further preferably a group represented by the formula (A-1), the formula (A-2), the formula (A-8), the formula (A-9), the formula (A-22), the formula (A-24) or the formulae (A-30) to (A-35), particularly preferably a group represented by the formula (A-1), the formula (A-2), the formula (A-8), the formula (A-22), the formula (A-24), the formula (A-30), the formula (A-32) or the formula (A-34), especially preferably a group represented by the formula (A-1), the formula (A-2), the formula (A-22), the formula (A-24) or the formula (A-34).

The substituent which $L^{H1}$ optionally has is preferably a halogen atom, an alkyl group, a cycloalkyl group, an alkoxy group, a cycloalkoxy group, an aryl group or a monovalent heterocyclic group, more preferably an alkyl group, an alkoxy group, an aryl group or a monovalent heterocyclic group, further preferably an alkyl group, an aryl group or a monovalent heterocyclic group, and these groups optionally further have a substituent.

$L^{H21}$ is preferably a single bond or an arylene group, more preferably a single bond, and this arylene group optionally has a substituent.

The definition and examples of the arylene group or divalent heterocyclic group represented by $L^{H21}$ are the same as the definition and examples of the arylene group or divalent heterocyclic group represented by $L^{H1}$.

$R^{H21}$ is preferably an aryl group or a monovalent heterocyclic group, and these groups each optionally have a substituent.

The definition and examples of the aryl group and the monovalent heterocyclic group represented by $R^{H21}$ are the same as the definition and examples of the aryl group and the monovalent heterocyclic group represented by $Ar^{H1}$ and $Ar^{H2}$.

The definition and examples of the substituent which $R^{H21}$ optionally has are the same as the definition and examples of the substituent which $Ar^{H1}$ and $Ar^{H2}$ may have.

The compound represented by the formula (H-1) is preferably a compound represented by the formula (H-2).

$$Ar^{H1}-\left[L^{H1}\right]_{n^{H3}}-Ar^{H2} \qquad \textbf{(H-2)}$$

[wherein, $Ar^{H1}$, $Ar^{H2}$, $n^{H3}$ and $L^{H1}$ represent the same meaning as described above.]

As the compound represented by the formula (H-1), compounds represented by the following formulae (H-101)

to (H-118) are exemplified.

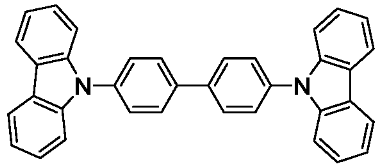

(H-101)

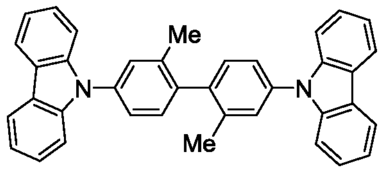

(H-102)

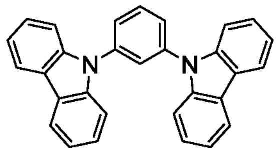

(H-103)

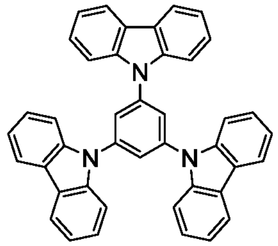

(H-104)

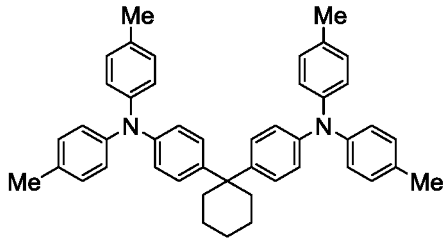

(H-105)

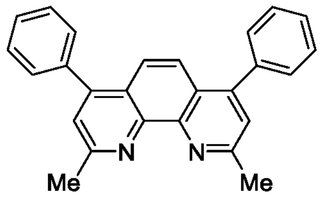

(H-106)

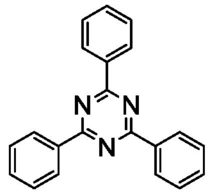

(H-107)

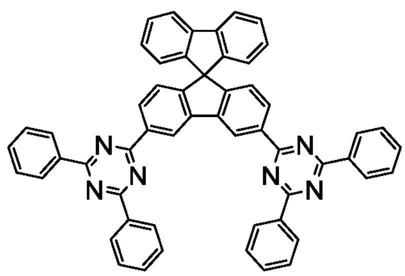

(H-108)

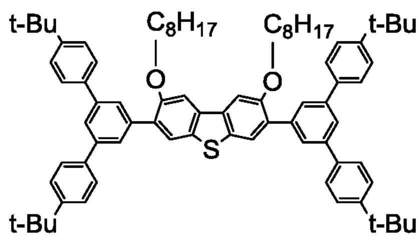

(H-109)

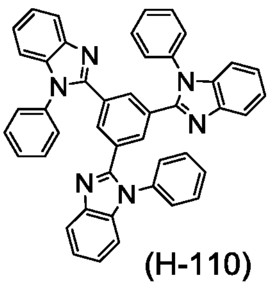

(H-110)

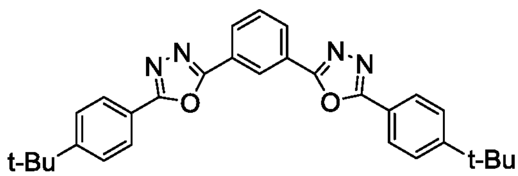

(H-111)

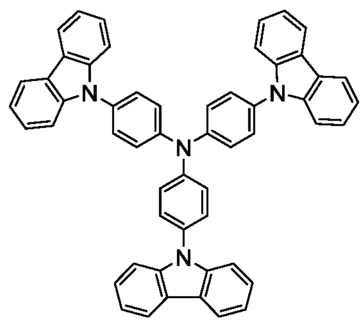

(H-112)

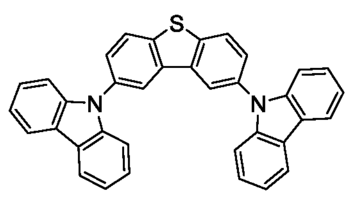

(H-113)

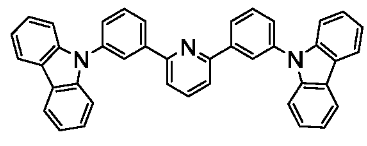

(H-114)

(H-112)

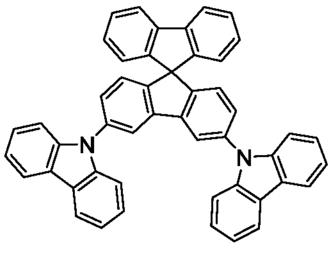

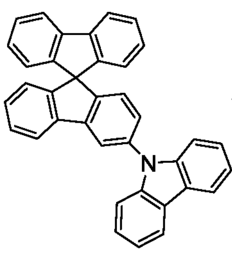

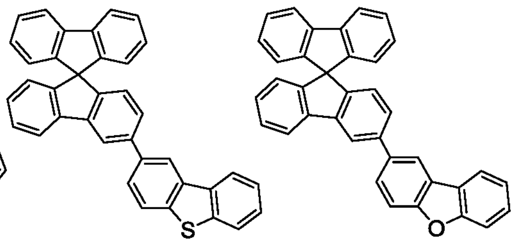

(H-115) (H-116) (H-117) (H-118)

These low molecular weight materials may be used in combination with a triplet light emission complex described later.

In the light emitting device of the present invention, it is preferable that the light emitting layer comprises a polymer compound comprising a constitutional unit represented by the following formula (Y).

$$-[ArY^1]- \qquad (Y)$$

[wherein, $Ar^{Y1}$ represents an arylene group, a divalent heterocyclic group or a divalent group in which at least one arylene group and at least one divalent heterocyclic group are bonded directly to each other, and these groups each optionally have a substituent.]

The arylene group represented by $Ar^{Y1}$ is more preferably a group represented by the formula (A-1), the formula (A-2), the formulae (A-6) to (A-10), the formula (A-19) or the formula (A-20), further preferably a group represented by the formula (A-1), the formula (A-2), the formula (A-7), the formula (A-9) or the formula (A-19), and these groups each optionally have a substituent.

The divalent heterocyclic group represented by $Ar^{Y1}$ is more preferably a group represented by the formulae (A-21) to (A-24), the formulae (A-30) to (A-35), the formulae (A-38) to (A-41), the formula (A-53) or the formula (A-54), further preferably a group represented by the formula (A-24), the formula (A-30), the formula (A-32), the formula (A-34) or the formula (A-53), and these groups each optionally have a substituent.

The more preferable range and the further preferable range of the arylene group and the divalent heterocyclic group in the divalent group in which at least one arylene group and at least one divalent heterocyclic group are bonded directly to each other represented by $Ar^{Y1}$ are the same as the more preferable range and the further preferable range of the arylene group and the divalent heterocyclic group represented by Ar described above, respectively.

"The divalent group in which at least one arylene group and at least one divalent heterocyclic group are bonded directly to each other" includes, for example, groups represented by the following formulae, and each of them optionally has a substituent.

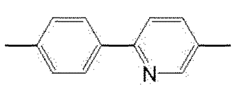

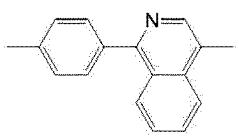

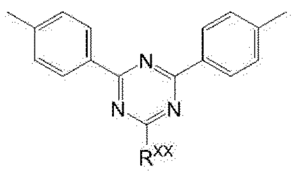

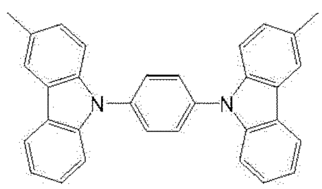

[wherein, $R^{XX}$ represents a hydrogen atom, an alkyl group, an aryl group or a monovalent heterocyclic group and these groups each optionally have a substituent.]

$R^{XX}$ is preferably an alkyl group or an aryl group, and these groups each optionally have a substituent.

The substituent which the group represented by $Ar^{Y1}$ optionally has is preferably an alkyl group or an aryl group, and these groups optionally further have a substituent.

The constitutional unit represented by the formula (Y) includes, for example, constitutional units represented by the formulae (Y-1) to (Y-13), and preferable from the standpoint of the luminance life in the initial period of driving of the light emitting device of the present invention are constitutional units represented by the formula (Y-1), (Y-2) or (Y-3), preferable from the standpoint of electron transportability are constitutional units represented by the formulae (Y-4) to (Y-7), and preferable from the standpoint of hole transportability are constitutional units represented by the formulae (Y-8) to (Y-10).

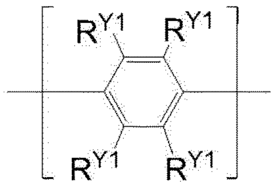

(Y-1)

[wherein, $R^{Y1}$ represents a hydrogen atom, an alkyl group, an alkoxy group, an aryl group or a monovalent heterocyclic group, and these groups each optionally have a substituent. The $R^{Y1}$s may be the same or different, and adj acent $R^{Y1}$ may be combined together to form a ring together with the carbon atoms to which they are attached.]

$R^{Y1}$ is preferably a hydrogen atom, an alkyl group or an aryl group, and these groups each optionally have a substituent.

The constitional unit represented by the formula (Y-1) may be a constitutional unit represented by the formula (Y-1').

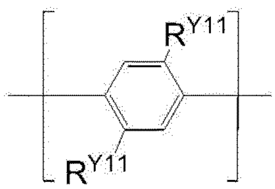

(Y-1')

[wherein, $R^{Y11}$ represents an alkyl group, an alkoxy group, an aryl group or a monovalent heterocyclic group and these groups each optionally have a substituent. The $R^{Y1}$s may be the same or different.]

$R^{Y11}$ is preferably an alkyl group or an aryl group, more preferably an alkyl group, and these groups each optionally have a substituent.

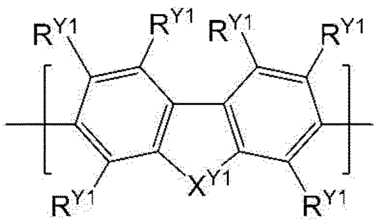

(Y-2)

[wherein, $R^{Y1}$ represents the same meaning as described above. $X^{Y1}$ represents a group represented by $-C(R^{Y2})_2-$, $-C(R^{Y2})=C(R^{Y2})-$ or $C(R^{Y2})_2-C(R^{Y2})_2-$. $R^{Y2}$ represents a hydrogen atom, an alkyl group, an alkoxy group, an aryl group or a monovalent heterocyclic group and these groups each optionally have a substituent. The $R^{Y2}$s may be the same or different, and these $R^{Y2}$ may be combined together to form a ring together with the carbon atoms to which they are attached.].

$R^{Y2}$ is preferably an alkyl group, an aryl group or a monovalent heterocyclic group, more preferably an alkyl group or an aryl group, and these groups each optionally have a substituent.

Regarding the combination of two $R^{Y2}$ in the group represented by $-C(R^{Y2})_2$ - in $X^{Y1}$, it is preferable that the both are an alkyl group, the both are an aryl group, the both are a monovalent heterocyclic group, or one is an alkyl group and the other is an aryl group or a monovalent heterocyclic group, it is more preferable that one is an alkyl group and the other is an aryl group, and these groups each optionally have a substituent. The two groups $R^{Y2}$ may be combined together to form a ring together with the atoms to which they are attached, and when the groups $R^{Y2}$ form a ring, the group represented by $-C(R^{Y2})_2-$ is preferably a group represented by the formulae (Y-A1) to (Y-A5), more preferably a group represented by the formula (Y-A4), and these groups each optionally have a substituent.

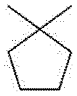

(Y-A1)

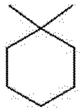

(Y-A2)

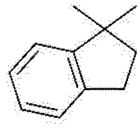

(Y-A3)

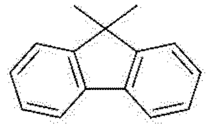

(Y-A4)

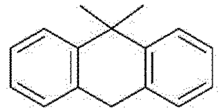

(Y-A5)

Regarding the combination of two $R^{Y2}$ in the group represented by $-C(R^{Y2})=C(R^{Y2})-$ in $X^{Y1}$, it is preferable that the both are an alkyl group, or one is an alkyl group and the other is an aryl group, and these groups each optionally have a substituent.

Four $R^{Y2}$ in the group represented by $-C(RY^2)_2-C(R^{Y2})_2-$ in $X^{Y1}$ are preferably an alkyl group which optionally has a substituent. The $R^{Y2}$s may be combined together to form a ring together with the atoms to which they are attached, and when the groups $R^{Y2}$ form a ring, the group represented by $-C(R^{Y2})_2-C(R^{Y2})_2-$ is preferably a group represented by the formulae (Y-B1) to (Y-B5), more preferably a group represented by the formula (Y-B3), and these groups each optionally have a substituent.

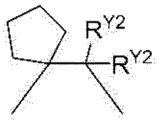

(Y-B1)

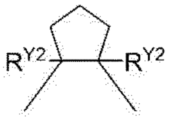

(Y-B2)

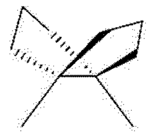

(Y-B3)

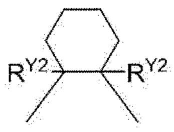

(Y-B4)

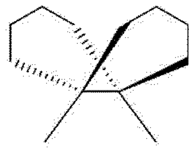

(Y-B5)

[wherein, $R^{Y2}$ represents the same meaning as described above.]

The constitutional unit represented by the formula (Y-2) may be a constitutional unit represented by the formula (Y-2').

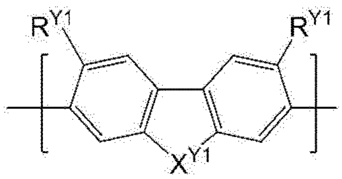

(Y-2')

[wherein, $R^{Y1}$ and $X^{Y1}$ represent the same meaning as described above.]

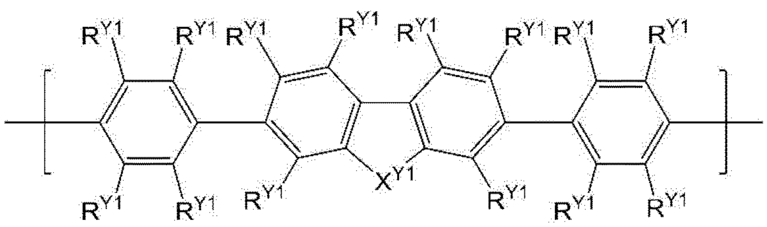

(Y-3)

[wherein, $R^{Y1}$ and $X^{Y1}$ represent the same meaning as described above.]

The constitutional unit represented by the formula (Y-3) may be a constitutional unit represented by the formula (Y-3').

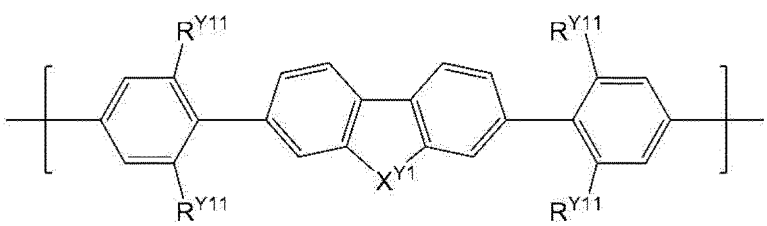

(Y-3')

[wherein, $R^{Y11}$ and $X^{Y1}$ represent the same meaning as described above.]

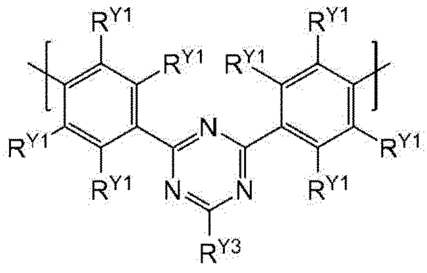

(Y-4)

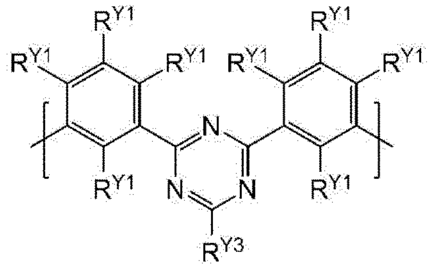

(Y-5)

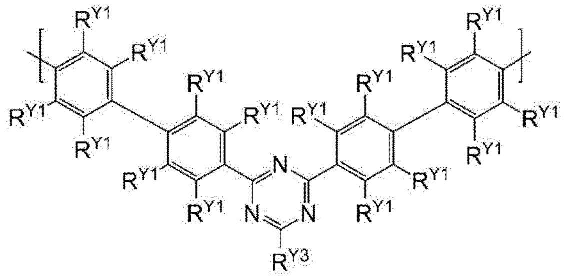

(Y-6)

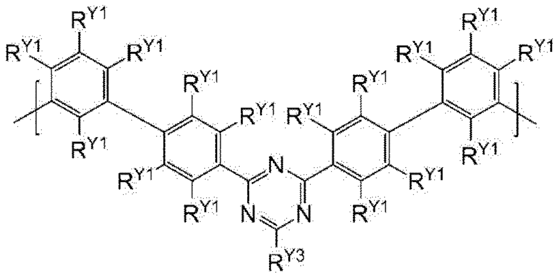

(Y-7)

[wherein, $R^{Y1}$ represents the same meaning as described above. $R^{Y3}$ represents a hydrogen atom, an alkyl group, an alkoxy group, an aryl group or a monovalent heterocyclic group and these groups each optionally have a substituent.].

$R^{Y3}$ is preferably an alkyl group, an alkoxy group, an aryl group or a monovalent heterocyclic group, more preferably an aryl group, and these groups each optionally have a substituent.

The constitutional unit represented by the formula (Y-4) may be a constitutional unit represented by the formula (Y-4'), and the constitutional unit represented by the formula (Y-6) may be a constitutional unit represented by the formula (Y-6').

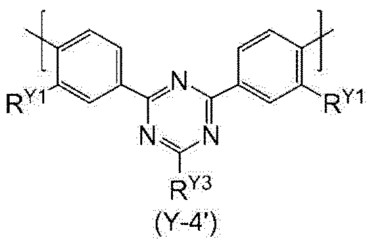

(Y-4')

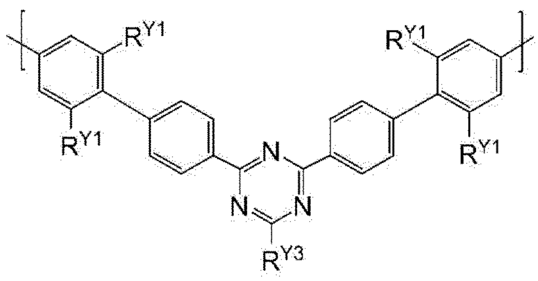

(Y-6')

[wherein, $R^{Y1}$ and $R^{Y3}$ represent the same meaning as described above.]

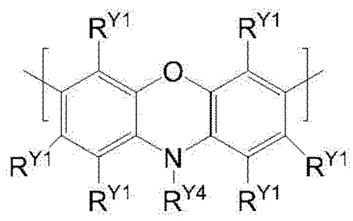

(Y-8)

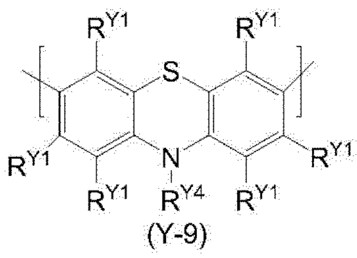

(Y-9)

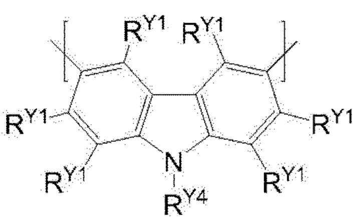

(Y-10)

[wherein, $R^{Y1}$ represents the same meaning as described above. $R^{Y4}$ represents a hydrogen atom, an alkyl group, an alkoxy group, an aryl group or a monovalent heterocyclic group and these groups each optionally have a substituent.].

$R^{Y4}$ is preferably an alkyl group, an alkoxy group, an aryl group or a monovalent heterocyclic group, more preferably an aryl group, and these groups each optionally have a substituent.

The constitutional unit represented by the formula (Y) includes, for example, a constitutional unit composed of an arylene group represented by the formulae (Y-101) to (Y-130), a constitutional unit composed of a divalent heterocyclic group represented by the formulae (Y-201) to (Y-207), and a constitutional unit composed of a divalent group in which at least one arylene group and at least one divalent heterocyclic group are bonded directly to each other represented by the formulae (Y-301) to (Y-308).

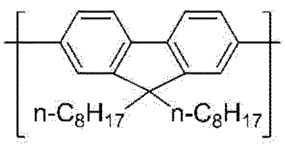
(Y-101)

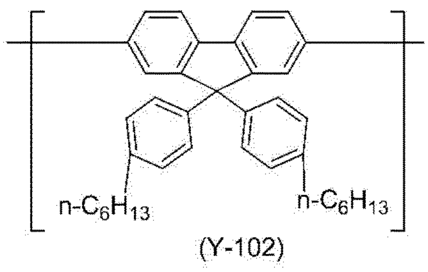
(Y-102)

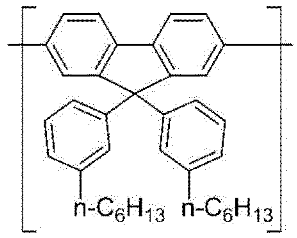
(Y-103)

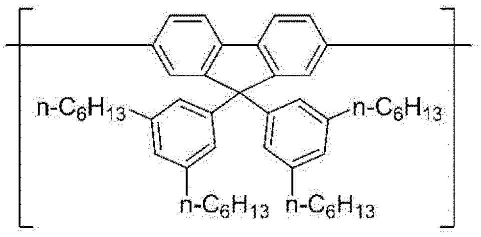
(Y-104)

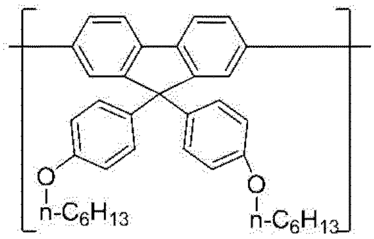
(Y-105)

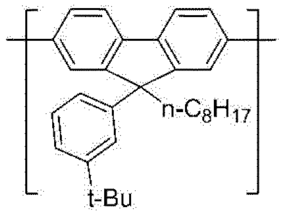
(Y-106)

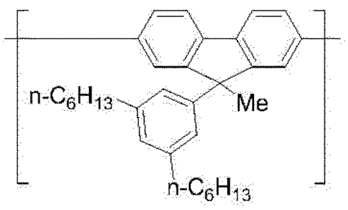
(Y-107)

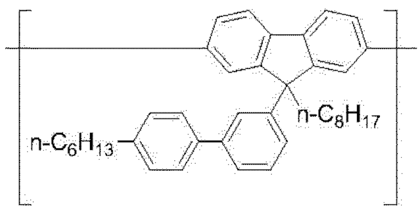
(Y-108)

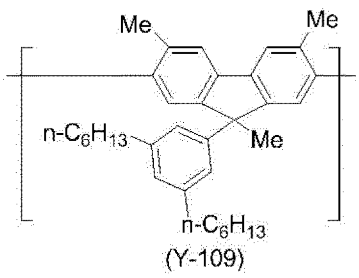
(Y-109)

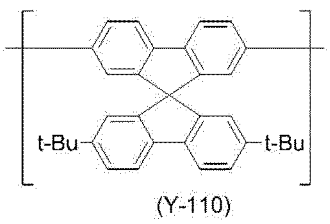
(Y-110)

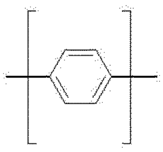
(Y-111)

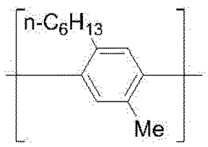
(Y-112)

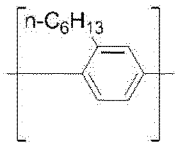
(Y-113)

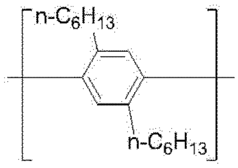
(Y-114)

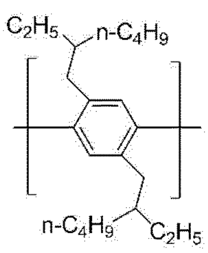
(Y-115)

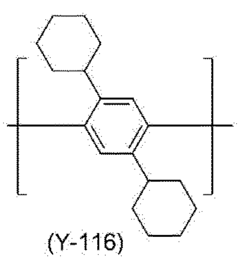
(Y-116)

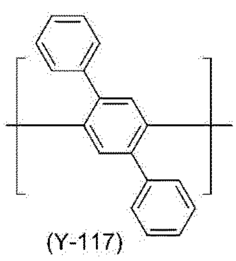
(Y-117)

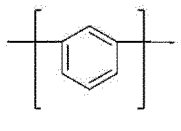
(Y-118)

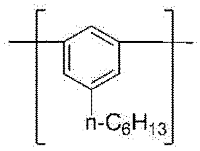
(Y-119)

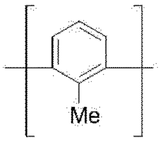
(Y-120)

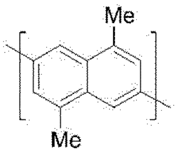
(Y-121)

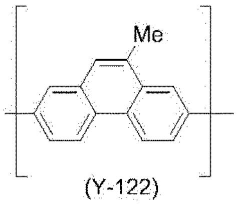
(Y-122)

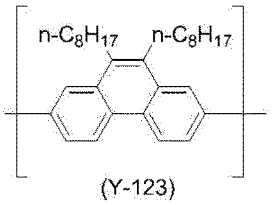
(Y-123)

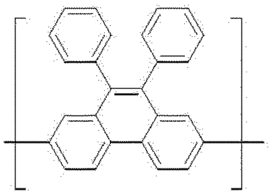
(Y-124)

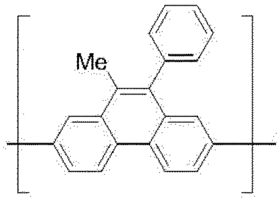
(Y-125)

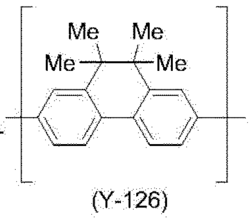
(Y-126)

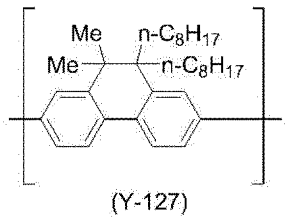
(Y-127)

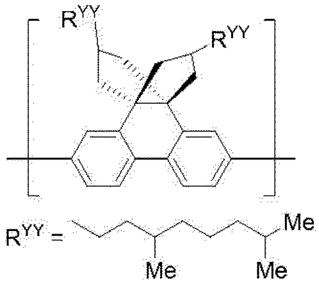
(Y-128)

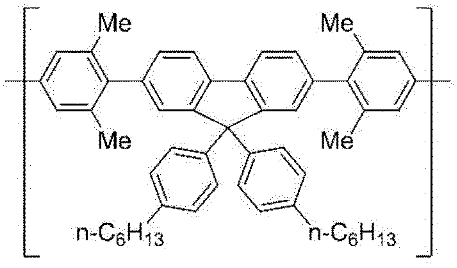
(Y-129)

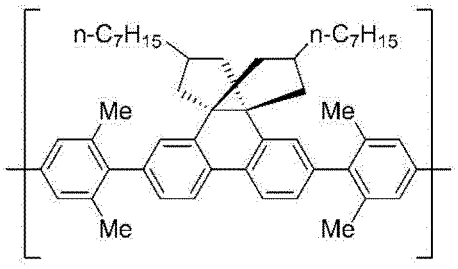
(Y-130)

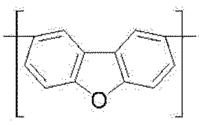
(Y-201)

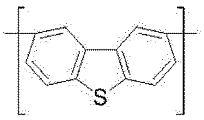
(Y-202)

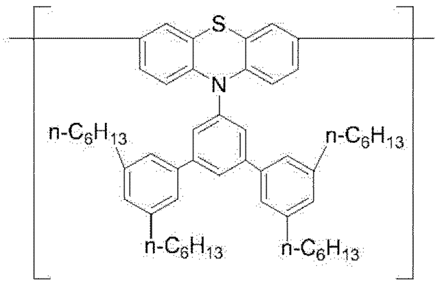
(Y-203)

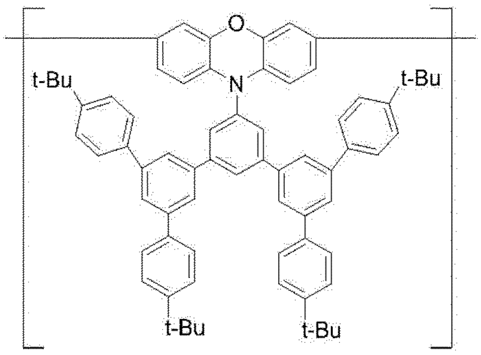
(Y-204)

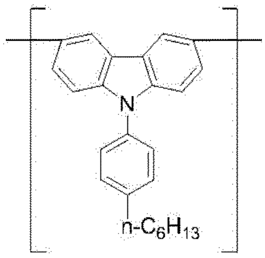

(Y-205)

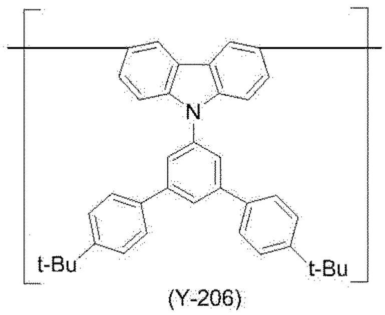

(Y-206)

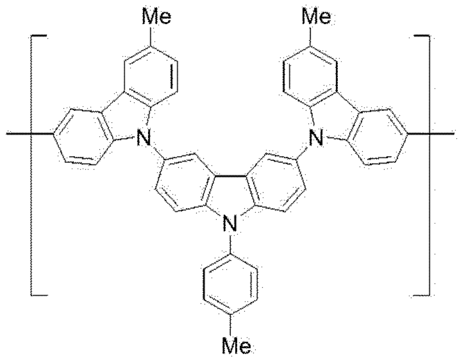

(Y-207)

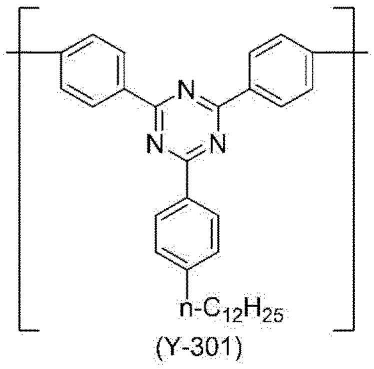

(Y-301)

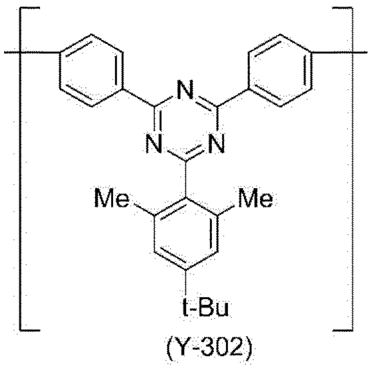

(Y-302)

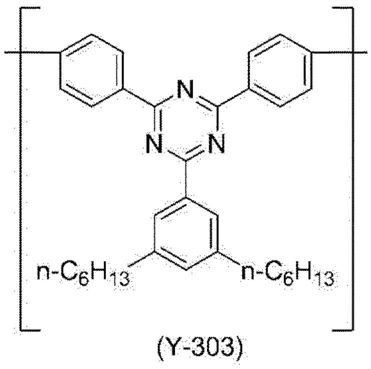

(Y-303)

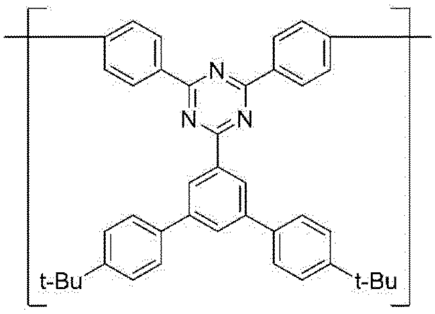

(Y-304)

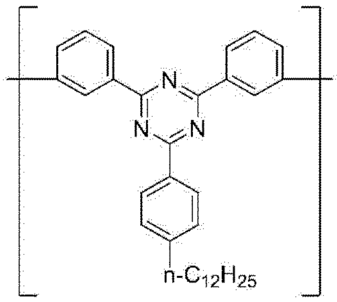

(Y-305)

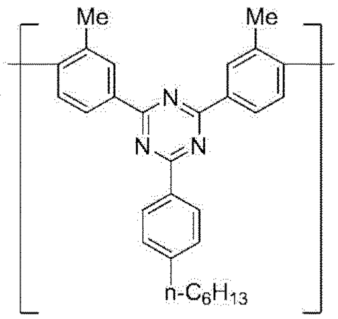

(Y-306)

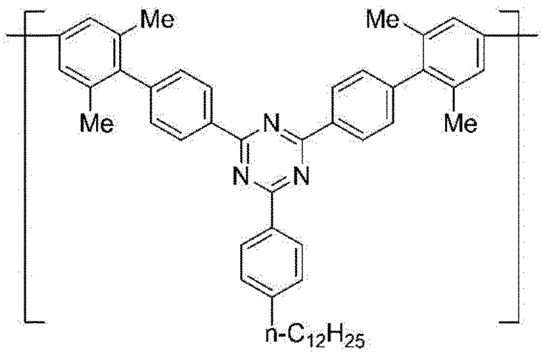

(Y-307)

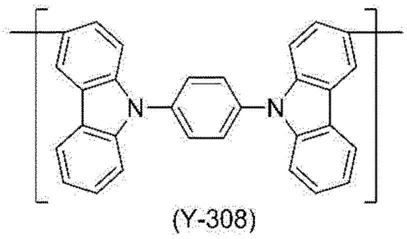

(Y-308)

When the polymer compound comprising the constitutional unit represented by the formula (Y) is a polymer compound showing fluorescence emission (for example, blue fluorescence emission and green fluorescence emission), the amount of the constitutional unit represented by the formula (Y) in which $Ar^{Y1}$ is an arylene group is preferably 10 to 95 mol%, more preferably 50 to 95 mol% with respect to the total amount of constitutional units contained in the

polymer compound, because the luminance life in the initial period of driving of a light emitting layer using the polymer compound is more excellent.

When the polymer compound comprising the constitutional unit represented by the formula (Y) is a charge transportable polymer compound used in combination with a triplet light emission complex showing phosphorescence emission (for example, green phosphorescence emission and red phosphorescence emission), the amount of the constitutional unit represented by the formula (Y) in which $Ar^{Y1}$ is an arylene group is preferably 50 to 100 mol%, more preferably 80 to 100 mol% with respect to the total amount of constitutional units contained in the polymer compound, because the luminance life in the initial period of driving of a light emitting layer using the polymer compound is more excellent.

When the polymer compound comprising the constitutional unit represented by the formula (Y) is a polymer compound showing fluorescence emission (for example, blue fluorescence emission and green fluorescence emission), the amount of the constitutional unit represented by the formula (Y) in which $Ar^{Y1}$ is a divalent heterocyclic group or a divalent group in which at least one arylene group and at least one divalent heterocyclic group are bonded directly to each other is preferably 1 to 10 mol%, more preferably 1 to 5 mol% with respect to the total amount of constitutional units contained in the polymer compound, because the charge transportability of the light emitting device of the present invention is excellent.

When the polymer compound comprising the constitutional unit represented by the formula (Y) is a charge transportable polymer compound used in combination with a triplet light emission complex showing phosphorescence emission (for example, green phosphorescence emission and red phosphorescence emission), the amount of the constitutional unit represented by the formula (Y) in which $Ar^{Y1}$ is a divalent heterocyclic group or a divalent group in which at least one arylene group and at least one divalent heterocyclic group are bonded directly to each other is preferably 5 to 20 mol%, more preferably 5 to 15 mol% with respect to the total amount of constitutional units contained in the polymer compound, because the charge transportability of the light emitting device of the present invention is excellent.

The constitutional unit represented by the formula (Y) may be contained only singly or two or more units thereof may be contained in the polymer compound.

It is preferable that the polymer compound comprising the constitutional unit represented by the formula (Y) further comprises a constitutional unit represented by the following formula (X), because then hole transportability is excellent.

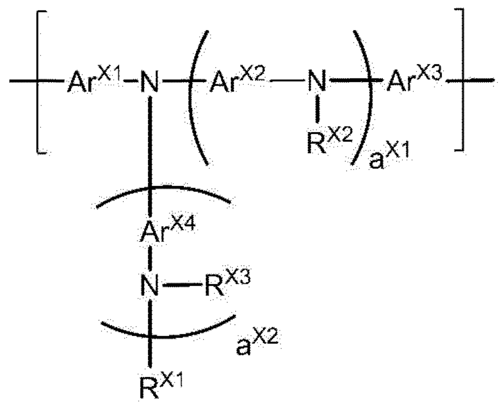

(X)

[wherein,

$a^{X1}$ and $a^{X2}$ each independently represent an integer of 0 or more.

$Ar^{X1}$ and $Ar^{X3}$ each independently represent an arylene group or a divalent heterocyclic group and these groups each optionally have a substituent.

$Ar^{X2}$ and $Ar^{X4}$ each independently represent an arylene group, a divalent heterocyclic group or a divalent group in which at least one arylene group and at least one divalent heterocyclic group are bonded directly to each other, and these groups each optionally have a substituent.

$R^{X1}$, $R^{X2}$ and $R^{X3}$ each independently represent a hydrogen, an alkyl group, an aryl group or a monovalent heterocyclic group and these groups each optionally have a substituent.]

$a^{X1}$ is preferably 2 or less, more preferably 1 because the luminance life in the initial period of driving of the light emitting device of the present invention is more excellent.

$a^{X2}$ is preferably 2 or less, more preferably 0 because the luminance life in the initial period of driving of the light emitting device of the present invention is more excellent.

$R^{X1}$, $R^{X2}$ and $R^{X3}$ are preferably an alkyl group, an aryl group or a monovalent heterocyclic group, more preferably an aryl group, and these groups each optionally have a substituent.

The arylene group represented by $Ar^{X1}$ and $Ar^{X3}$ is more preferably a group represented by the formula (A-1) or the formula (A-9), further preferably a group represented by the formula (A-1), and these groups each optionally have a substituent.

The divalent heterocyclic group represented by $Ar^{X1}$ and $Ar^{X3}$ is more preferably a group represented by the formula (A-21), the formula (A-22) or the formulae (A-27) to (A-46), and these groups each optionally have a substituent.

$Ar^{X1}$ and $Ar^{X3}$ are preferably an arylene group which optionally has a substituent.

The arylene group represented by $Ar^{X2}$ and $Ar^{X4}$ is more preferably a group represented by the formula (A-1), the formula (A-6), the formula (A-7), the formulae (A-9) to (A-11) or the formula (A-19), and these groups each optionally have a substituent.

The more preferable range of the divalent heterocyclic group represented by $Ar^{X2}$ and $Ar^{X4}$ is the same as the particularly preferable range of the divalent heterocyclic group represented by $Ar^{X1}$ and $Ar^{X3}$.

The more preferable range and the further preferable range of the arylene group and the divalent heterocyclic group in the divalent group in which at least one arylene group and at least one divalent heterocyclic group are bonded directly to each other represented by $Ar^{X2}$ and $Ar^{X4}$ are the same as the more preferable range and the further preferable range of the arylene group and the divalent heterocyclic group represented by $Ar^{X1}$ and $Ar^{X3}$, respectively.

The divalent group in which at least one arylene group and at least one divalent heterocyclic group are bonded directly to each other represented by $Ar^{X2}$ and $Ar^{X4}$ includes the same groups as the divalent group in which at least one arylene group and at least one divalent heterocyclic group are bonded directly to each other represented by $Ar^{Y1}$ in the formula (Y).

$Ar^{X2}$ and $Ar^{X4}$ are preferably an arylene group which optionally has a substituent.

The substituent which the group represented by $Ar^{X1}$ to $Ar^{X4}$ and $R^{X1}$ to $R^{X3}$ optionally has is preferably an alkyl group or an aryl group, and these groups optionally further have a substituent.

The constitutional unit represented by the formula (X) is preferably a constitutional unit represented by the formulae (X-1) to (X-7), more preferably a constitutional unit represented by the formulae (X-1) to (X-6), further preferably a constitutional unit represented by the formulae (X-3) to (X-6).

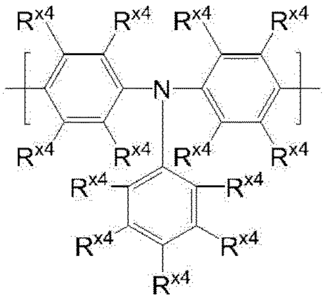
(X-1)

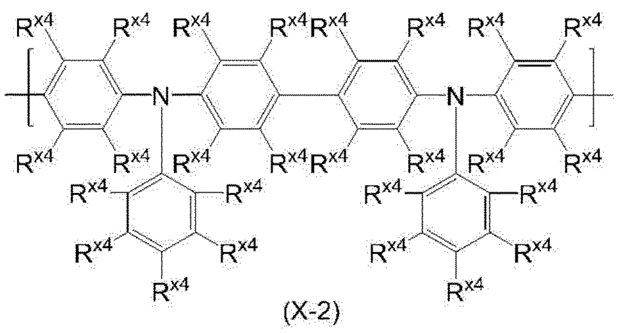
(X-2)

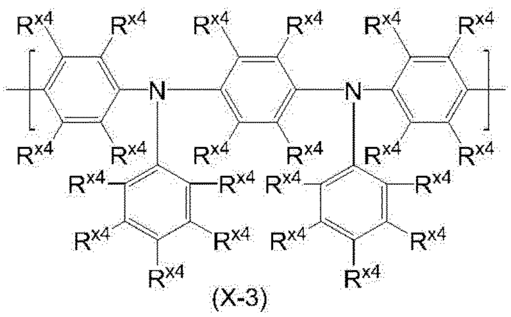
(X-3)

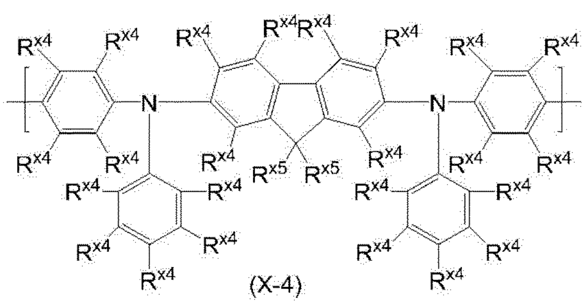
(X-4)

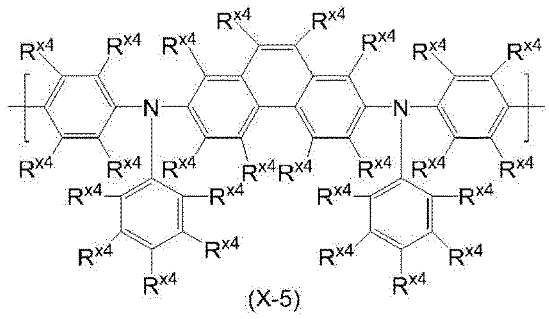
(X-5)

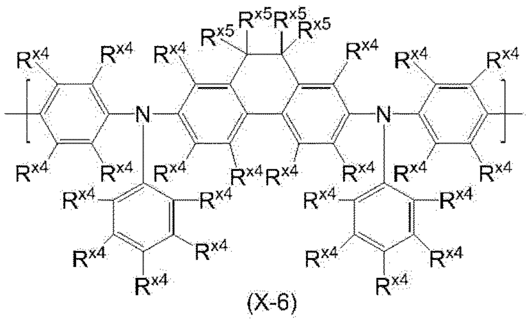
(X-6)

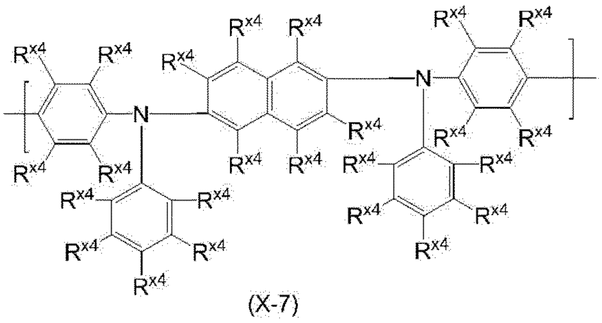
(X-7)

[wherein, $R^{X4}$ and $R^{X5}$ each independently represent a hydrogen atom, an alkyl group, an alkoxy group, an aryl group, an aryloxy group, a halogen atom, a monovalent heterocyclic group or a cyano group and these groups each optionally have a substituent. The $R^{X4}$ s may be the same or different. The $R^{X5}$ s may be the same or different, and adjacent groups $R^{X5}$ may be combined together to form a ring together with the carbon atoms to which they are attached.]

The constitutional unit represented by the formula (X) includes, for example, constitutional units represented by the formulae (X1-1) to (X1-19), preferably constitutional units represented by the formulae (X1-1) to (X1-14).

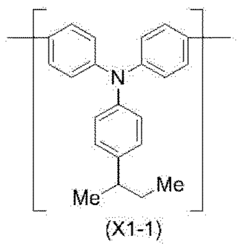
(X1-1)

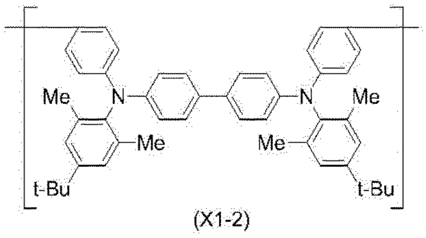
(X1-2)

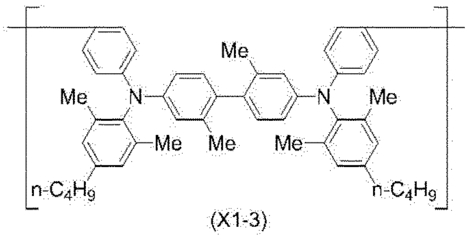
(X1-3)

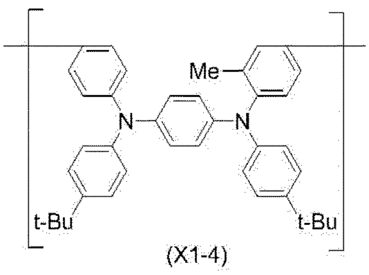
(X1-4)

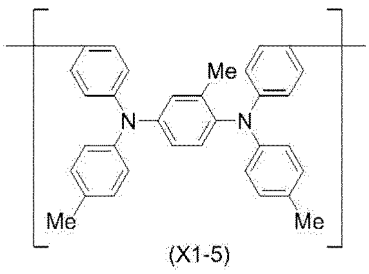
(X1-5)

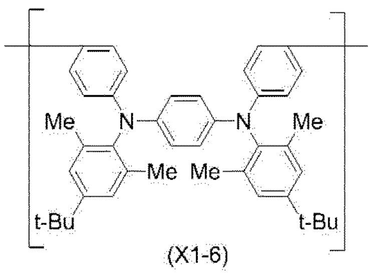
(X1-6)

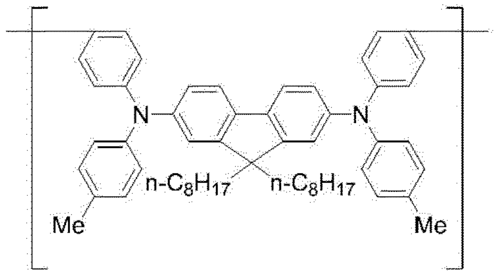

(X1-7)

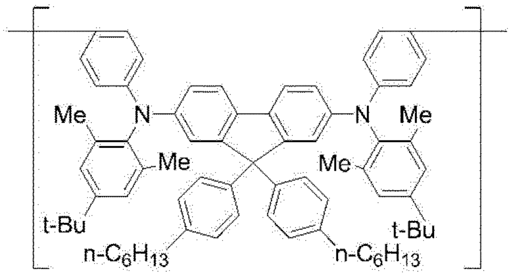

(X1-8)

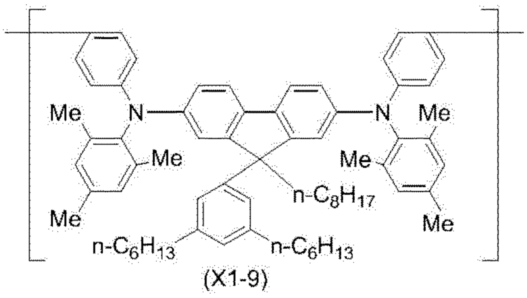

(X1-9)

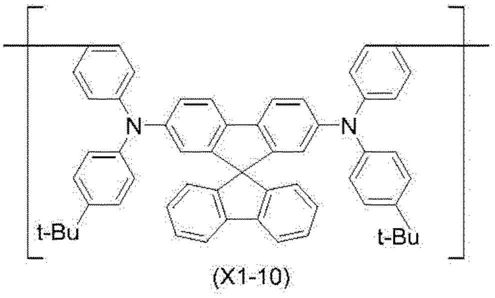

(X1-10)

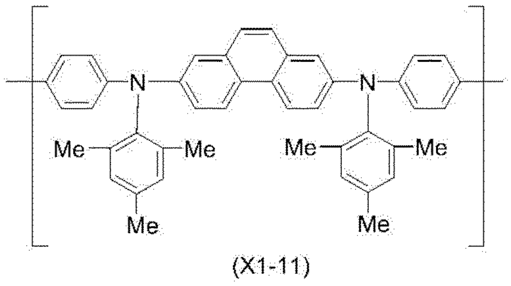

(X1-11)

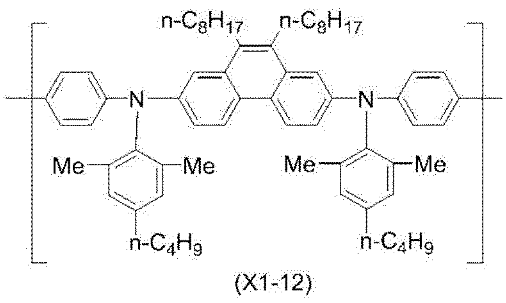

(X1-12)

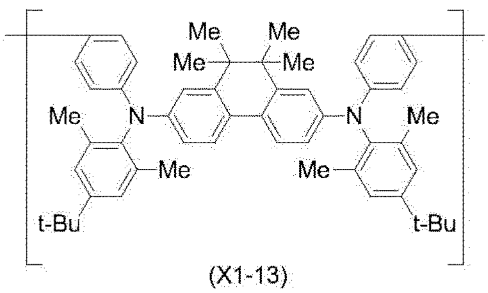

(X1-13)

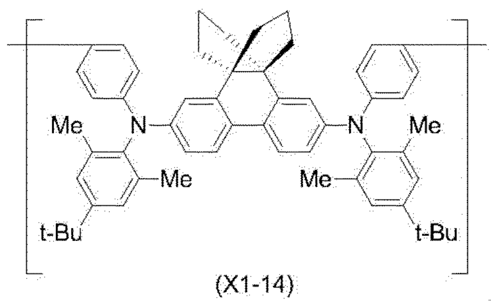

(X1-14)

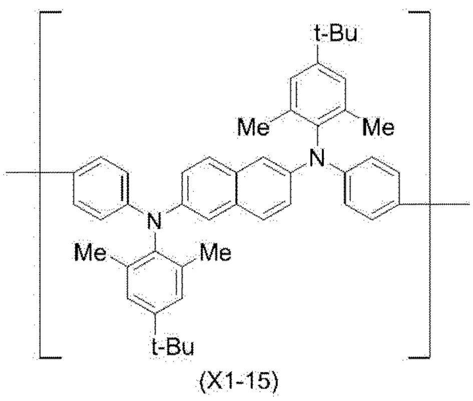

(X1-15)

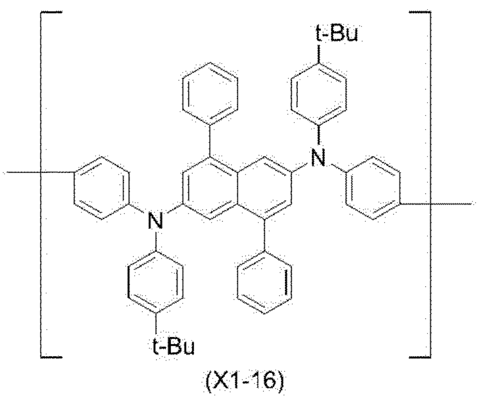

(X1-16)

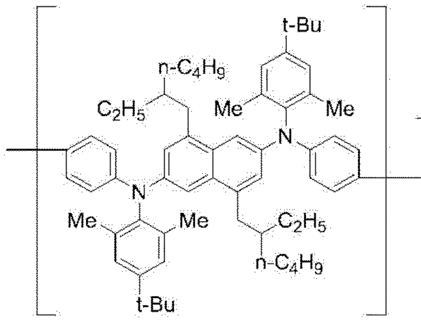

(X1-17)

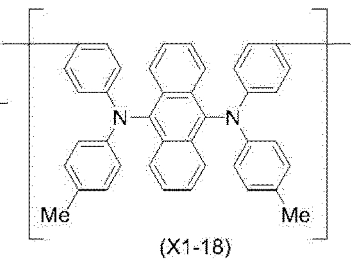

(X1-18)

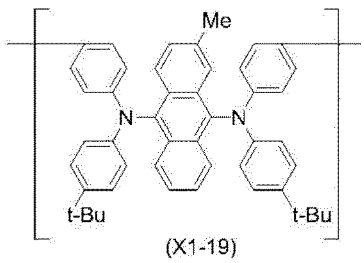

(X1-19)

When the polymer compound comprising the constitutional unit represented by the formula (Y) and the constitutional unit represented by the formula (X) is a polymer compound showing fluorescence emission (for example, blue fluorescence emission and green fluorescence emission), the amount of the constitutional unit represented by the formula (X) is preferably 1 to 15 mol%, more preferably 1 to 10 mol%, further preferably 1 to 5 mol% with respect to the total amount of constitutional units contained in the polymer compound, because hole transportability is excellent.

When the polymer compound comprising the constitutional unit represented by the formula (Y) and the constitutional unit represented by the formula (X) is a charge transportable polymer compound used in combination with a triplet light emission complex showing phosphorescence emission (for example, green phosphorescence emission and red phosphorescence emission), the amount of the constitutional unit represented by the formula (X) is preferably 0 to 20 mol%, more preferably 0 to 15 mol%, further preferably 0 to 10 mol% with respect to the total amount of constitutional units contained in the polymer compound, because hole transportability is excellent.

The constitutional unit represented by the formula (X) may be contained only singly or two or more units thereof may be contained in the polymer compound.

The polymer compound may be a block copolymer, a random copolymer, an alternative copolymer or a graft copolymer, and may also be another embodiment. The polymer compound is preferably a copolymer obtained by copolymerizing a plurality of raw material monomers as described above.

The polymer compound comprising the constitutional unit represented by the formula (Y) includes, for example, polymer compounds P-1 to P-6 in the following Table 1. Here, "other" constitutional units denote constitutional units other than the constitutional unit represented by the formula (Y) and the constitutional unit represented by the formula (X).

[Table 1]

| polymer compound | constitutional unit and mole fraction thereof | | | | |
|---|---|---|---|---|---|
| | formula (Y) | | | formula ( X) | other |
| | formulae (Y-1) to (Y-3) | formulae (Y-4) to (Y-7) | formulae (Y-8) to (Y-10) | formulae (X-1) to (X-7) | |
| | p | q | r | s | t |
| P-1 | 0.1 to 99.9 | 0.1 to 99.9 | 0 | 0 | 0 to 30 |
| P-2 | 0.1 to 99.9 | 0 | 0.1 to 99.9 | 0 | 0 to 30 |
| P-3 | 0.1 to 99.8 | 0.1 to 99.8 | 0 | 0.1 to 99.8 | 0 to 30 |
| P-4 | 0.1 to 99.8 | 0.1 to 99.8 | 0.1 to 99.8 | 0 | 0 to 30 |
| P-5 | 0.1 to 99.8 | 0 | 0.1 to 99.8 | 0.1 to 99.8 | 0 to 30 |
| P-6 | 0.1 to 99.7 | 0.1 to 99.7 | 0.1 to 99.7 | 0.1 to 99.7 | 0 to 30 |

[In the table, p, q, r, s and t represent the mole fraction of each constitutional unit. p+q+r+s+t = 100, and 100 ≥ p+q+r+s

≥ 70. Other constitutional unit denotes a constitutional unit other than the constitutional unit represented by the formula (Y) and the constitutional unit represented by the formula (X).]

In the light emitting device of the present invention, the light emitting layer preferably comprises a triplet light emission complex, more preferably comprises a polymer compound represented by the formula (Y) and a triplet light emission complex.

As the triplet light emission complex, triplet light emission complexes having iridium as the central metal are preferable, and iridium complexes represented by the formulae Ir-1 to Ir-3 are more preferable.

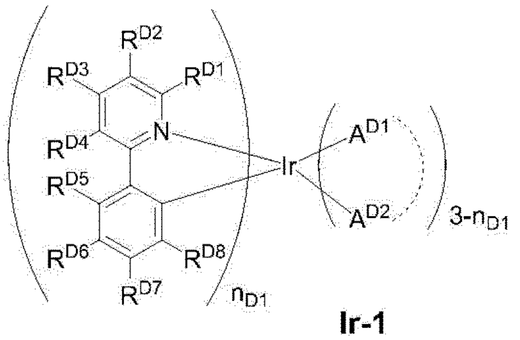

Ir-1

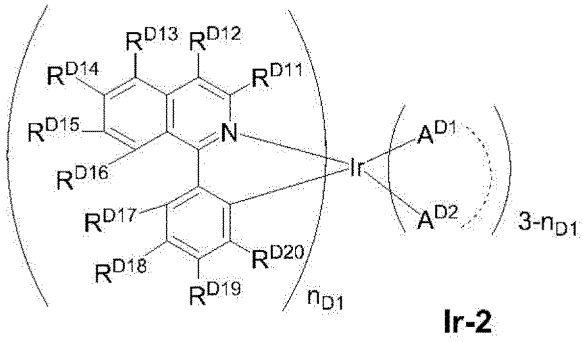

Ir-2

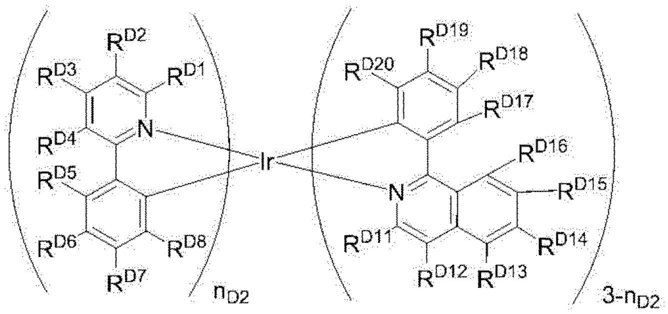

Ir-3

[wherein,

$R^{D1}$ to $R^{D8}$ and $R^{D11}$ to $R^{D20}$ each independently represent a hydrogen atom, an alkyl group, an alkoxy group, an aryl group, an aryloxy group, a monovalent heterocyclic group or a halogen atom and these groups each optionally have a substituent.

$-A^{D1}$---$A^{D2}$-represents an anionic bidentate ligand, and $A^{D1}$ and $A^{D2}$ each independently represent a carbon atom, an oxygen atom or a nitrogen atom linking to an iridium atom.

$n_{D1}$ represents 1, 2 or 3, and $n_{D2}$ represents 1 or 2.]

In the triplet light emitting complex represented by the Ir-1, at least one of $R^{D1}$ to $R^{D8}$ is preferably a group represented by the formula (D-A).

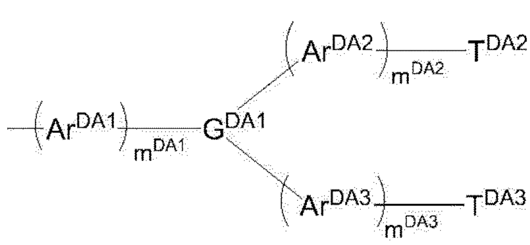

**(D-A)**

[wherein,

$m^{DA1}$, $m^{DA2}$ and $m^{DA3}$ each independently represent an integer of 0 or more.

$G^{DA1}$ represents a nitrogen atom, an aromatic hydrocarbon group or a heterocyclic group and these groups each optionally have a substituent.

$Ar^{DA1}$, $Ar^{DA2}$ and $Ar^{DA3}$ each independently represent an arylene group or a divalent heterocyclic group and these groups each optionally have a substituent. When there are a plurality of $Ar^{DA1}$, a plurality of $Ar^{DA2}$ and a plurality of $Ar^{DA3}$, each of them may be the same or different.

$T^{DA2}$ and $T^{DA3}$ each independently represent an aryl group or a monovalent heterocyclic group and these

groups each optionally have a substituent.]

$m^{DA1}$, $m^{DA2}$ and $m^{DA3}$ represent usually an integer of 10 or less, preferably an integer of 5 or less, more preferably 0 or 1. It is preferable that $m^{DA1}$, $m^{DA2}$ and $m^{DA3}$ are the same integer.

$G^{DA1}$ includes preferably groups represented by the formulae (GDA-11) to (GDA-15) and these groups each optionally have a substituent.

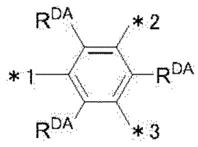
(GDA-11)

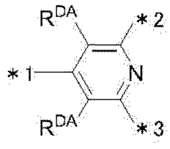
(GDA-12)

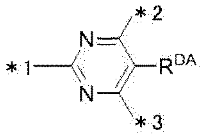
(GDA-13)

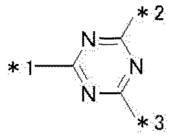
(GDA-14)

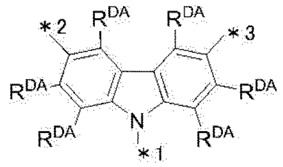
(GDA-15)

[wherein,
*1, *2 and *3 each represent a linkage to $Ar^{DA1}$, $Ar^{DA2}$ and $Ar^{DA3}$.

$R^{DA}$ represents a hydrogen atom, an alkyl group, an alkoxy group, an aryl group or a monovalent heterocyclic group and these groups optionally further have a substituent. When there are a plurality of $R^{DA}$, they may be the same or different.]

$R^{DA}$ is preferably a hydrogen atom, an alkyl group or an alkoxy group, more preferably a hydrogen atom or an alkyl group, and these groups each optionally have a substituent.

$Ar^{DA1}$, $Ar^{DA2}$ and $Ar^{DA3}$ are preferably groups represented by the formulae (ArDA-1) to (ArDA-3).

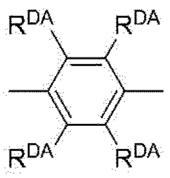
**(ArDA-1)**

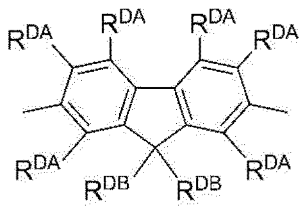
**(ArDA-2)**

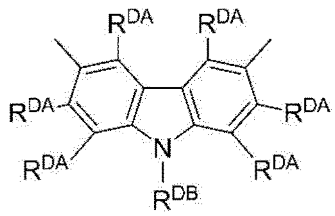
**(ArDA-3)**

[wherein,
$R^{DA}$ represents the same meaning as described above.

$R^{DB}$ represents a hydrogen atom, an alkyl group, an aryl group or a monovalent heterocyclic group and these groups each optionally have a substituent. When there are a plurality of $R^{DB}$, they may be the same or different.]

$T^{DA2}$ and $T^{DA3}$ are preferably groups represented by formulae (TDA-1) to (TDA-3).

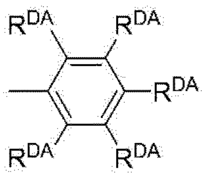
**(TDA-1)**

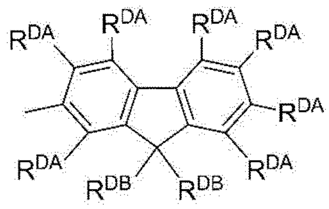
**(TDA-2)**

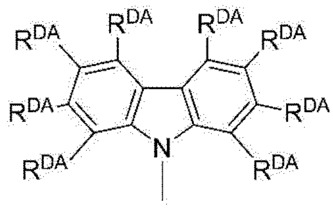
**(TDA-3)**

[wherein, $R^{DA}$ and $R^{DB}$ represent the same meaning as described above.]

In the formula Ir-2, at least one of $R^{D11}$ to $R^{D20}$ is preferably a group represented by the formula (D-A).

In the formula Ir-3, at least one of $R^{D1}$ to $R^{D8}$ and $R^{D11}$ to $R^{D20}$ is preferably a group represented by the formula (D-A) .

The group represented by the formula (D-A) is preferably a group represented by the formulae (D-A1) to (D-A3).

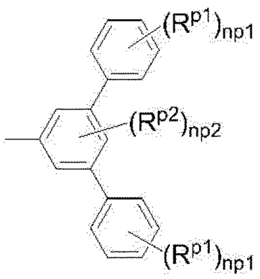 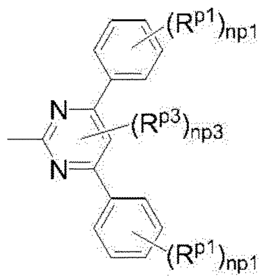 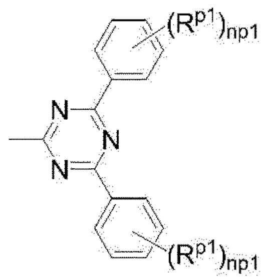

(D-A1) (D-A2) (D-A3)

[wherein,

$R^{p1}$, $R^{p2}$ and $R^{p3}$ each independently represent an alkyl group, an alkoxy group or halogen atom. When there are a plurality of $R^{p1}$ and a plurality of $R^{p2}$, each of them may be the same or different.

np1 represents an integer of 0 to 5, np2 represents an integer of 0 to 3, and np3 represents 0 or 1. The np1s may be the same or different.]

np1 is preferably 0 or 1, more preferably 1. np2 is preferably 0 or 1, more preferably 0. np3 is preferably 0.

The anionic bidentate ligand represented by $-A^{D1}$---$A^{D2}$-includes, for example, ligands represented by the following formulae.

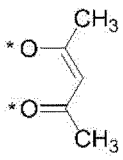 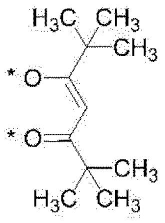 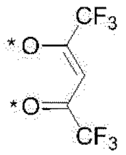 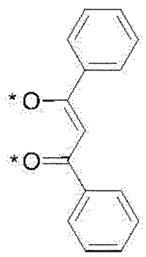 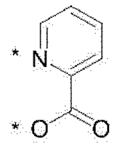 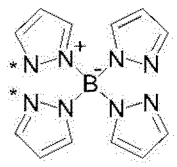

[wherein, * represents a position linking to Ir.]

The metal complex represented by the formula Ir-1 includes preferably metal complexes represented by the formulae Ir-11 to Ir-13. The metal complex represented by the formula Ir-2 is preferably a metal complex represented by the formula Ir-21. The metal complex represented by the formula Ir-3 includes preferably metal complexes represented by the formulae Ir-31 to Ir-33.

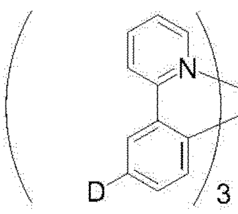

Ir-11

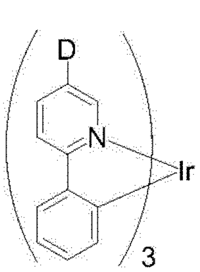

Ir-12

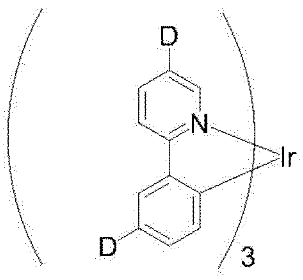

Ir-13

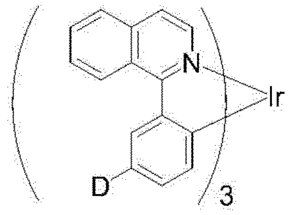

Ir-21

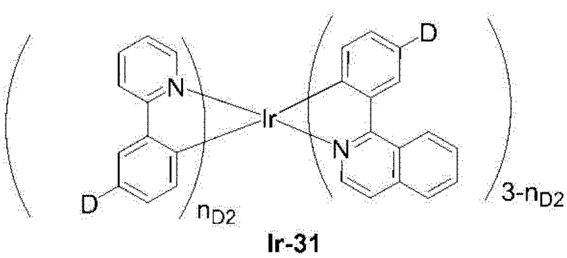

Ir-31

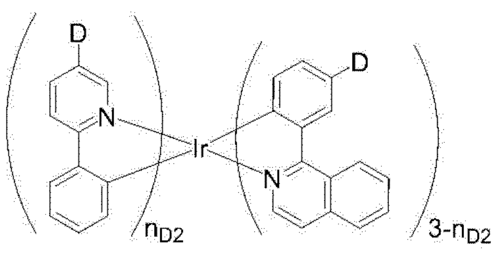

Ir-32

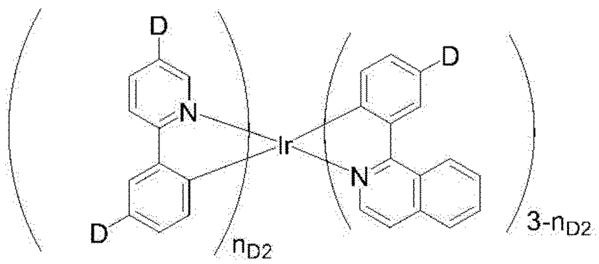

Ir-33

[wherein, D represents a group represented by the formula (D-A) . $n_{D2}$ represents 1 or 2.]

The triplet light emitting complex includes, for example, metal complexes listed below.

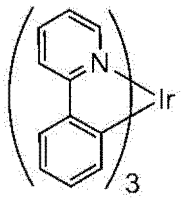

Ir(ppy)$_3$

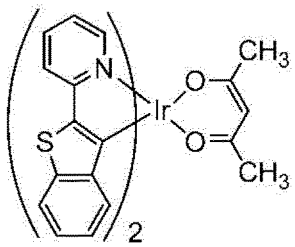

Btp$_2$Ir(acac)

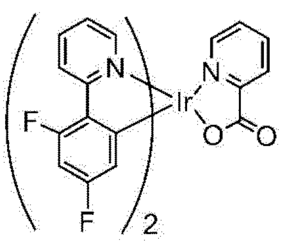

FIrpic

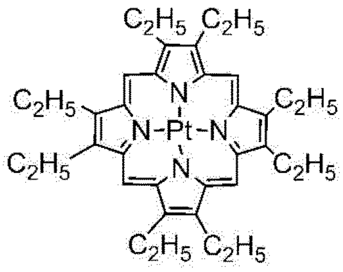

PtOEP

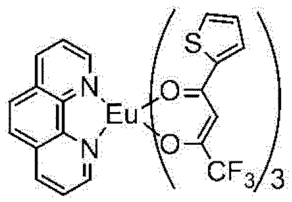

Eu(TTA)$_3$phen

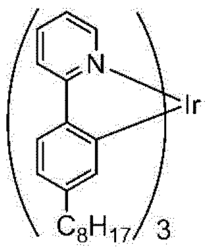

COM-1

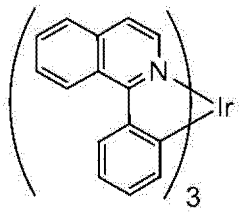

COM-2

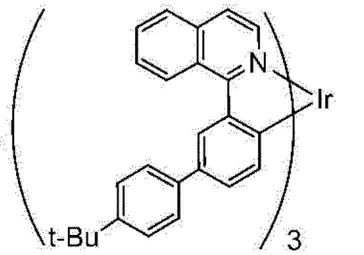

COM-3

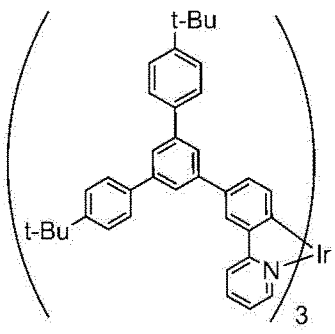

COM-4

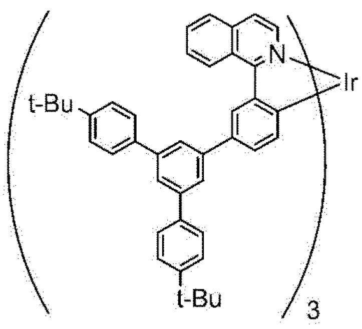

COM-5

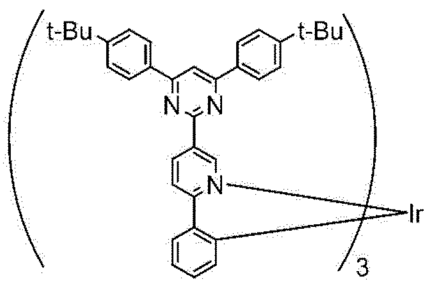

COM-6

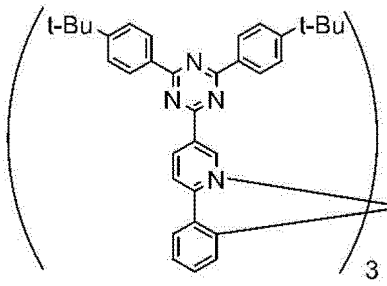

COM-7

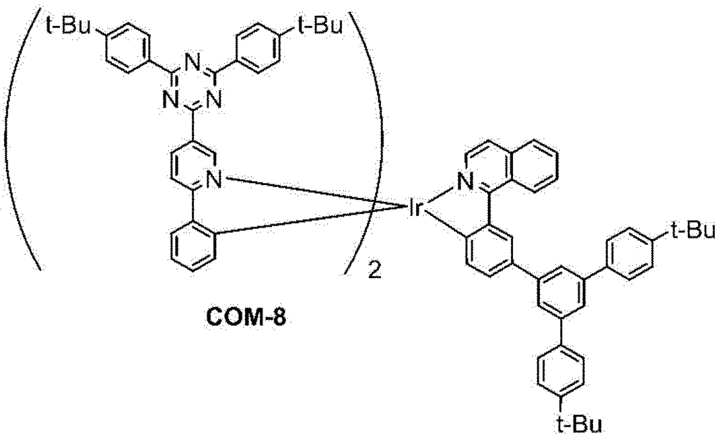

COM-8

In the light emitting device of the present invention, when the light emitting layer comprises a polymer compound represented by the formula (Y) and a triplet light emission complex, the content of the triplet light emission complex is usually 0.1 to 400 parts by weight with respect to 100 parts by weight of the polymer compound represented by the formula (Y).

EXAMPLES

The present invention will be illustrated further in detail by examples below, but the present invention is not limited to these examples.

In the present examples, the polystyrene-equivalent number average molecular weight (Mn) and the polystyrene-equivalent weight average molecular weight (Mw) of a polymer compound were measured by size exclusion chromatography (SEC) (manufactured by Shimadzu Corp., trade name: LC-10Avp). SEC measurement conditions are as described below.

[Measurement condition]

The polymer compound to be measured was dissolved in tetrahydrofuran at a concentration of about 0.05 wt%, and 10 μL of the solution was injected into SEC. As the mobile phase of SEC, tetrahydrofuran was used and allowed to flow at a flow rate of 2.0 mL/min. As the column, PLgel MIXED-B (manufactured by Polymer Laboratories) was used. As the detector, UV-VIS detector (manufactured by Shimadzu Corp., trade name: SPD-10Avp) was used.

In the present examples, the glass transition temperature TG (°C) of a material was determined by a thermal analysis DSC instrument (manufactured by TA Instrument, trade name: type Q2000, differential scanning calorimeter). The glass transition temperature was determined by temperature-modulated DSC measurement as described below.

[Measurement condition]

A material to be measured was weighed (3 to 5 mg) and added into an aluminum sample pan, then, encapsulated by pressing. Then, the sample pan enclosing the material and an aluminum empty sample pan (reference substance) were set in a measuring chamber of a thermal analysis DSC instrument, then, a nitrogen gas atmosphere was prepared in the measuring chamber. Then, the measuring chamber was adjusted to a temperature of 20°C and kept for 5 minutes until equilibrium state, then, the frequency of temperature modulation was set at 60 seconds and the amplitude at ± 0.75°C, and the measuring chamber was further kept for 5 minutes. Then, the measuring chamber was heated up to 200°C at a constant rate of 10°C/minutes and kept at 200°C for 1 minute, then, quenched to -50°C and kept for 5 minutes. Thereafter, the measuring chamber was heated up to 310°C at a constant rate of 10°C/minute and a DSC curve was measured during heating from -50°C to 310°C. For the glass transition temperature of the material to be measured in the DSC curve, the base line shifted to the downward direction (endothermic direction), and thereafter, returned to the original base line. Therefore, the average value of the temperature at which the base line shifted to the downward direction (endothermic direction) and the temperature at which it returned to the original base line was regarded as the glass transition temperature TG (°C) of the material to be measured.

<Comparative Example CD1: Fabrication and evaluation of light emitting device CD1>

On a glass substrate carrying thereon an ITO film with a thickness of 45 nm formed by a sputtering method, a

polythiophene•sulfonic acid type hole injection agent AQ-1200 (manufactured by Plectronics) as a hole injection material was spin-coated to form a film with a thickness of 35 nm, and this was heated on a hot plate at 170°C for 15 minutes in an air atmosphere.

Next, a xylene solution of the hole transportable polymer compound P1 (glass transition temperature: 155°C) was spin-coated to form a hole transporting layer with a thickness of 20 nm, and this was heated on a hot plate at 180°C for 60 minutes in a nitrogen gas atmosphere.

Next, a xylene solution of the blue fluorescence emitting polymer compound P2 (glass transition temperature: 144°C) was spin-coated to form a light emitting layer with a thickness of 60 nm, and this was heated on a hot plate at 150°C for 10 minutes in a nitrogen gas atmosphere.

Next, sodium fluoride was vapor-deposited with a thickness of about 7 nm as an electron injection layer, then, aluminum was vapor-deposited with a thickness of about 120 nm as a cathode. After the degree of vacuum reached $1\times10^{-4}$ Pa or less, vapor deposition of a metal was initiated.

Next, under a nitrogen gas atmosphere, an encapsulating layer was formed by using a carved glass substrate having a carved part on which a desiccant HD-071407W-50 (manufactured by Dynic Corporation) had been pasted, to fabricate a light emitting device CD1.

Since the carved glass substrate is used for the formation of the encapsulating layer, a space exists between an anode, a cathode and other layers which a light emitting layer carries and the carved glass substrate. Since the formation of the encapsulating layer is conducted under a nitrogen gas atmosphere, a nitrogen gas is filled in the space.

When voltage was applied to the light emitting device CD1, EL light emission showing a maximum peak at 455 nm was obtained, and the light emission efficiency in emission at 1000 cd/$m^2$ was 12.1 cd/A. The current value was set so that the initial luminance was 1000 cd/$m^2$, then, the device was driven with constant current, and the time change of luminance was measured. The time until the luminance became 95% of the initial luminance (hereinafter, referred to also as "LT95") was 7.2 hours. The results are shown in Table 2.

<Example D1: Fabrication and evaluation of light emitting device D1>

A light emitting device D1 was fabricated in the same manner as in Comparative Example CD1 excepting that the device was heated at 80°C for 10 minutes on a hot plate in an air atmosphere after the formation of the encapsulating layer, in Comparative Example CD1.

When voltage was applied to the light emitting device D1, EL light emission showing a maximum peak at 455 nm was obtained, and the current density when 5 V was applied was 0.75-fold of the current density when 5 V was applied of the light emitting device CD1. The light emission efficiency in emission at 1000 cd/$m^2$ was 11.9 cd/A. The current value was set so that the initial luminance was 1000 cd/$m^2$, then, the device was driven with constant current, and the time change of luminance was measured. The time until the luminance became 95% of the initial luminance was 13.2 hours. The results are shown in Table 2.

<Example D2: Fabrication and evaluation of light emitting device D2>

A light emitting device D2 was fabricated in the same manner as in Comparative Example CD1 excepting that the device was heated at 80°C for 30 minutes on a hot plate in an air atmosphere after the formation of the encapsulating layer, in Comparative Example CD1.

When voltage was applied to the light emitting device D2, EL light emission showing a maximum peak at 455 nm was obtained, and the current density when 5 V was applied was 0.76-fold of the current density when 5 V was applied of the light emitting device CD1. The light emission efficiency in emission at 1000 cd/$m^2$ was 11.7 cd/A. The current value was set so that the initial luminance was 1000 cd/$m^2$, then, the device was driven with constant current, and the time change of luminance was measured. The time until the luminance became 95% of the initial luminance was 13.2 hours. The results are shown in Table 2.

<Example D3: Fabrication and evaluation of light emitting device D3>

A light emitting device D3 was fabricated in the same manner as in Comparative Example CD1 excepting that the device was heated at 50°C for 72 hours in an oven in an air atmosphere after the formation of the encapsulating layer, in Comparative Example CD1.

When voltage was applied to the light emitting device D3, EL light emission showing a maximum peak at 455 nm was obtained, and the current density when 5 V was applied was 0.75-fold of the current density when 5 V was applied of the light emitting device CD1. The light emission efficiency in emission at 1000 cd/$m^2$ was 11.8 cd/A. The current value was set so that the initial luminance was 1000 cd/$m^2$, then, the device was driven with constant current, and the time change of luminance was measured. The time until the luminance became 95% of the initial luminance

was 19.9 hours. The results are shown in Table 2.

[Table 2]

| Light emitting device | Light emitting layer | Annealing treatment | IB/IA | LT95 |
|---|---|---|---|---|
| CD1 | P2 (TG = 144°C) | - | - | 7.2 hours |
| D1 | P2 (TG = 144°C) | 80°C (TA), 10 minutes | 0.75 | 13.2 hours |
| D2 | P2 (TG = 144°C) | 80°C (TA), 30 minutes | 0.76 | 13.2 hours |
| D3 | P2 (TG = 144°C) | 50°C (TA), 72 hours | 0.75 | 19.9 hours |

<Comparative Example CD2: Fabrication and evaluation of light emitting device CD2>

A light emitting device CD2 was fabricated in the same manner as in Comparative Example CD1 excepting that the thickness of the hole transporting layer was 10 nm, the blue fluorescence emitting polymer compound P3 (glass transition temperature: 140°C) was used instead of the blue fluorescence emitting polymer compound P2 and the thickness of the light emitting layer was 50 nm, in Comparative Example CD1.

When voltage was applied to the light emitting device CD2, EL light emission showing a maximum peak at 455 nm was obtained, and the light emission efficiency in emission at 1000 cd/$m^2$ was 10.2 cd/A. The current value was set so that the initial luminance was 8000 cd/$m^2$, then, the device was driven with constant current, and the time change of luminance was measured. The time until the luminance became 95% of the initial luminance was 0.44 hours. The results are shown in Table 3.

<Example D4: Fabrication and evaluation of light emitting device D4>

A light emitting device D4 was fabricated in the same manner as in Comparative Example CD2 excepting that the device was heated at 50°C for 36 hours in an oven in an air atmosphere after the formation of the encapsulating layer, in Comparative Example CD2.

When voltage was applied to the light emitting device D4, EL light emission showing a maximum peak at 455 nm was obtained, and the current density when 5 V was applied was 0.93-fold of the current density when 5 V was applied of the light emitting device CD2. The light emission efficiency in emission at 1000 cd/$m^2$ was 10.3 cd/A. The current value was set so that the initial luminance was 8000 cd/$m^2$, then, the device was driven with constant current, and the time change of luminance was measured. The time until the luminance became 95% of the initial luminance was 0.82 hours. The results are shown in Table 3.

<Example D5: Fabrication and evaluation of light emitting device D5>

A light emitting device D5 was fabricated in the same manner as in Comparative Example CD2 excepting that the device was heated at 60°C for 10 minutes on a hot plate in an air atmosphere after the formation of the encapsulating layer, in Comparative Example CD2.

When voltage was applied to the light emitting device D5, EL light emission showing a maximum peak at 455 nm was obtained, and the current density when 5 V was applied was 0.84-fold of the current density when 5 V was applied of the light emitting device CD2. The light emission efficiency in emission at 1000 cd/$m^2$ was 10.6 cd/A. The current value was set so that the initial luminance was 8000 cd/$m^2$, then, the device was driven with constant current, and the time change of luminance was measured. The time until the luminance became 95% of the initial luminance was 0.62 hours. The results are shown in Table 3.

<Example D6: Fabrication and evaluation of light emitting device D6>

A light emitting device D6 was fabricated in the same manner as in Comparative Example CD2 excepting that the device was heated at 60°C for 30 minutes on a hot plate in an air atmosphere after the formation of the encapsulating layer, in Comparative Example CD2.

When voltage was applied to the light emitting device D6, EL light emission showing a maximum peak at 455 nm was obtained, and the current density when 5 V was applied was 0.80-fold of the current density when 5 V was applied of the light emitting device CD2. The light emission efficiency in emission at 1000 cd/$m^2$ was 10.4 cd/A. The current value was set so that the initial luminance was 8000 cd/$m^2$, then, the device was driven with constant current, and the time change of luminance was measured. The time until the luminance became 95% of the initial luminance

was 0.60 hours. The results are shown in Table 3.

<Example D7: Fabrication and evaluation of light emitting device D7>

A light emitting device D7 was fabricated in the same manner as in Comparative Example CD2 excepting that the device was heated at 60°C for 60 minutes on a hot plate in an air atmosphere after the formation of the encapsulating layer, in Comparative Example CD2.

When voltage was applied to light emitting device D7, EL light emission showing a maximum peak at 455 nm was obtained, and the current density when 5 V was applied was 0.81-fold of the current density when 5 V was applied of the light emitting device CD2. The light emission efficiency in emission at 1000 cd/$m^2$ was 9.8 cd/A. The current value was set so that the initial luminance was 8000 cd/$m^2$, then, the device was driven with constant current, and the time change of luminance was measured. The time until the luminance became 95% of the initial luminance was 0.77 hours. The results are shown in Table 3.

<Example D8: Fabrication and evaluation of light emitting device D8>

A light emitting device D8 was fabricated in the same manner as in Comparative Example CD2 excepting that the device was heated at 80°C for 10 minutes on a hot plate in an air atmosphere after the formation of the encapsulating layer, in Comparative Example CD2.

When voltage was applied to the light emitting device D8, EL light emission showing a maximum peak at 455 nm was obtained, and the current density when 5 V was applied was 0.91-fold of the current density when 5 V was applied of the light emitting device CD2. The light emission efficiency in emission at 1000 cd/$m^2$ was 10.3 cd/A. The current value was set so that the initial luminance was 8000 cd/$m^2$, then, the device was driven with constant current, and the time change of luminance was measured. The time until the luminance became 95% of the initial luminance was 0.62 hours. The results are shown in Table 3.

<Example D9: Fabrication and evaluation of light emitting device D9>

A light emitting device D9 was fabricated in the same manner as in Comparative Example CD2 excepting that the device was heated at 80°C for 30 minutes on a hot plate in an air atmosphere after the formation of the encapsulating layer, in Comparative Example CD2.

When voltage was applied to the light emitting device D9, EL light emission showing a maximum peak at 455 nm was obtained, and the current density when 5 V was applied was 0.77-fold of the current density when 5 V was applied of the light emitting device CD2. The light emission efficiency in emission at 1000 cd/$m^2$ was 10.0 cd/A. The current value was set so that the initial luminance was 8000 cd/$m^2$, then, the device was driven with constant current, and the time change of luminance was measured. The time until the luminance became 95% of the initial luminance was 0.99 hours. The results are shown in Table 3.

<Example D10: Fabrication and evaluation of light emitting device D10>

A light emitting device D10 was fabricated in the same manner as in Comparative Example CD2 excepting that the device was heated at 80°C for 60 minutes on a hot plate in an air atmosphere after the formation of the encapsulating layer, in Comparative Example CD2.

When voltage was applied to the light emitting device D10, EL light emission showing a maximum peak at 455 nm was obtained, and the current density when 5 V was applied was 0.79-fold of the current density when 5 V was applied of the light emitting device CD2. The light emission efficiency in emission at 1000 cd/$m^2$ was 10.9 cd/A. The current value was set so that the initial luminance was 8000 cd/$m^2$, then, the device was driven with constant current, and the time change of luminance was measured. The time until the luminance became 95% of the initial luminance was 0.93 hours. The results are shown in Table 3.

<Example D11: Fabrication and evaluation of light emitting device D11>

A light emitting device D11 was fabricated in the same manner as in Comparative Example CD2 excepting that the device was heated at 100°C for 10 minutes on a hot plate in an air atmosphere after the formation of the encapsulating layer, in Comparative Example CD2.

When voltage was applied to the light emitting device D11, EL light emission showing a maximum peak at 455 nm was obtained, and the current density when 5 V was applied was 0.95-fold of the current density when 5 V was applied of the light emitting device CD2. The light emission efficiency in emission at 1000 cd/$m^2$ was 9.2 cd/A. The

current value was set so that the initial luminance was 8000 cd/$m^2$, then, the device was driven with constant current, and the time change of luminance was measured. The time until the luminance became 95% of the initial luminance was 1.34 hours. The results are shown in Table 3.

[Table 3]

| Light emitting device | Light emitting layer | Annealing treatment | IB/IA | LT95 |
|---|---|---|---|---|
| CD2 | P3 (TG = 140°C) | - | - | 0.44 hours |
| D4 | P3 (TG = 140°C) | 50°C (TA), 36 hours | 0.93 | 0.82 hours |
| D5 | P3 (TG = 140°C) | 60°C (TA), 10 minutes | 0.84 | 0.62 hours |
| D6 | P3 (TG = 140°C) | 60°C (TA), 30 minutes | 0.80 | 0.60 hours |
| D7 | P3 (TG = 140°C) | 60°C (TA), 60 minutes | 0.81 | 0.77 hours |
| D8 | P3 (TG = 140°C) | 80°C (TA), 10 minutes | 0.91 | 0.62 hours |
| D9 | P3 (TG = 140°C) | 80°C (TA), 30 minutes | 0.77 | 0.99 hours |
| D10 | P3 (TG = 140°C) | 80°C (TA), 60 minutes | 0.79 | 0.93 hours |
| D11 | P3 (TG = 140°C) | 100°C (TA), 10 minutes | 0.95 | 1.34 hours |

<Comparative Example CD3: Fabrication and evaluation of light emitting device CD3>

A light emitting device CD3 was fabricated in the same manner as in Comparative Example CD1 excepting that the hole transportable polymer compound P4 (glass transition temperature: 121°C) was used instead of the hole transportable polymer compound P1, a composition obtained by mixing the charge transportable polymer compound P5 (glass transition temperature: 97°C) and the green phosphorescence emitting iridium complex M1 (glass transition temperature: 297°C) at a ratio of 60 wt%:40 wt% was used instead of the blue fluorescence emitting polymer compound P2, and the thickness of the light emitting layer was 80 nm, in Comparative Example CD1.

When voltage was applied to the light emitting device CD3, EL light emission showing a maximum peak at 525 nm was obtained, and the light emission efficiency in emission at 1000 cd/$m^2$ was 63.3 cd/A. The current value was set so that the initial luminance was 3000 cd/$m^2$, then, the device was driven with constant current, and the time change of luminance was measured. The time until the luminance became 95% of the initial luminance was 11.8 hours. The results are shown in Table 4.

<Example D12: Fabrication and evaluation of light emitting device D12>

A light emitting device D12 was fabricated in the same manner as in Comparative Example CD3 excepting that the device was heated at 50°C for 150 hours in an oven in an air atmosphere after the formation of the encapsulating layer, in Comparative Example CD3.

When voltage was applied to the light emitting device D12, EL light emission showing a maximum peak at 525 nm was obtained, and the current density when 5 V was applied was 0.81-fold of the current density when 5 V was applied of the light emitting device CD3. The light emission efficiency in emission at 1000 cd/$m^2$ was 65.4 cd/A. The current value was set so that the initial luminance was 3000 cd/$m^2$, then, the device was driven with constant current, and the time change of luminance was measured. The time until the luminance became 95% of the initial luminance was 118.6 hours. The results are shown in Table 4.

[Table 4]

| Light emitting device | Light emitting layer | Annealing treatment | IB/IA | LT95 |
|---|---|---|---|---|
| CD3 | P5 (TG = 97°C) M1 (TG = 297°C) | - | - | 11.8 hours |
| D12 | P5 (TG = 97°C) M1 (TG = 297°C) | 50°C (TA), 150 hours | 0.81 | 118.6 hours |

<Comparative Example CD4: Fabrication and evaluation of light emitting device CD4>

A light emitting device CD4 was fabricated in the same manner as in Comparative Example CD3 excepting that the charge transportable polymer compound P6 (glass transition temperature: 100°C) was used instead of the

charge transportable polymer compound P5, in Comparative Example CD3.

When voltage was applied to the light emitting device CD4, EL light emission showing a maximum peak at 525 nm was obtained, and the light emission efficiency in emission at 1000 cd/$m^2$ was 70.6 cd/A. The current value was set so that the initial luminance was 3000 cd/$m^2$, then, the device was driven with constant current, and the time change of luminance was measured. The time until the luminance became 95% of the initial luminance was 29.0 hours. The results are shown in Table 5.

<Example D13: Fabrication and evaluation of light emitting device D13>

A light emitting device D13 was fabricated in the same manner as in Comparative Example CD4 excepting that the device was heated at 50°C for 150 hours in an oven in an air atmosphere after the formation of the encapsulating layer, in Comparative Example CD4.

When voltage was applied to the light emitting device D13, EL light emission showing a maximum peak at 525 nm was obtained, and the current density when 5 V was applied was 0.79-fold of the current density when 5 V was applied of the light emitting device CD4. The light emission efficiency in emission at 1000 cd/$m^2$ was 70.6 cd/A. The current value was set so that the initial luminance was 3000 cd/$m^2$, then, the device was driven with constant current, and the time change of luminance was measured. The time until the luminance became 95% of the initial luminance was 215.7 hours. The results are shown in Table 5.

[Table 5]

| Light emitting device | Light emitting layer | Annealing treatment | IB/IA | LT95 |
|---|---|---|---|---|
| CD4 | P6 (TG = 100°C) M1 (TG = 297°C) | - | - | 29.0 hours |
| D13 | P6 (TG = 100°C) M1 (TG = 297°C) | 50°C (TA), 150 hours | 0.79 | 215.7 hours |

<Comparative Example CD5: Fabrication and evaluation of light emitting device CD5>

A light emitting device CD5 was fabricated in the same manner as in Comparative Example CD3 excepting that the charge transportable polymer compound P7 (glass transition temperature: 99°C) was used instead of the charge transportable polymer compound P5, in Comparative Example CD3.

When voltage was applied to the light emitting device CD5, EL light emission showing a maximum peak at 525 nm was obtained, and the light emission efficiency in emission at 1000 cd/$m^2$ was 81.4 cd/A. The current value was set so that the initial luminance was 3000 cd/$m^2$, then, the device was driven with constant current, and the time change of luminance was measured. The time until the luminance became 95% of the initial luminance was 48.9 hours. The results are shown in Table 6.

<Example D14: Fabrication and evaluation of light emitting device D14>

A light emitting device D14 was fabricated in the same manner as in Comparative Example CD5 excepting that the device was heated at 50°C for 150 hours in an oven in an air atmosphere after the formation of the encapsulating layer, in Comparative Example CD5.

When voltage was applied to the light emitting device D14, EL light emission showing a maximum peak at 525 nm was obtained, and the current density when 5 V was applied was 0.74-fold of the current density when 5 V was applied of the light emitting device CD5. The light emission efficiency in emission at 1000 cd/$m^2$ was 81.9 cd/A. The current value was set so that the initial luminance was 3000 cd/$m^2$, then, the device was driven with constant current, and the time change of luminance was measured. The time until the luminance became 95% of the initial luminance was 148.6 hours. The results are shown in Table 6.

[Table 6]

| Light emitting device | Light emitting layer | Annealing treatment | IB/IA | LT95 |
|---|---|---|---|---|
| CD5 | P7 (TG = 99°C) M1 (TG = 297°C) | - | - | 48.9 hours |
| D14 | P7 (TG = 99°C) M1 (TG = 297°C) | 50°C (TA), 150 hours | 0.74 | 148.6 hours |

<Comparative Example CD6: Fabrication and evaluation of light emitting device CD6>

A light emitting device CD6 was fabricated in the same manner as in Comparative Example CD3 excepting that the hole transportable polymer compound P1 (glass transition temperature: 155°C) was used instead of the hole transportable polymer compound P4 (glass transition temperature: 121°C), and a composition obtained by mixing the charge transportable polymer compound P8 (glass transition temperature: 148°C) and the red phosphorescence emitting iridium complex M2 (glass transition temperature: >148°C, the glass transition temperature of the red phosphorescence emitting iridium complex M2 was not measured at temperatures not higher than the glass transition temperature of the charge transportable polymer compound P8) at a ratio of 92.5 wt%:7.5 wt% was used instead of the composition obtained by mixing the charge transportable polymer compound P5 (glass transition temperature: 97°C) and the green phosphorescence emitting iridium complex M1 (glass transition temperature: 297°C) at a ratio of 60 wt%:40 wt%, in Comparative Example CD3.

When voltage was applied to the light emitting device CD6, EL light emission showing a maximum peak at 620 nm was obtained, and the light emission efficiency in emission at 1000 cd/$m^2$ was 19.1 cd/A. The current value was set so that the initial luminance was 3000 cd/$m^2$, then, the device was driven with constant current, and the time change of luminance was measured. The time until the luminance became 97% of the initial luminance was 121.1 hours. The results are shown in Table 7.

<Example D15: Fabrication and evaluation of light emitting device D15>

A light emitting device D15 was fabricated in the same manner as in Comparative Example CD6 excepting that the device was heated at 80°C for 60 minutes on a hot plate in an air atmosphere after the formation of the encapsulating layer, in Comparative Example CD6.

When voltage was applied to the light emitting device D15, EL light emission showing a maximum peak at 620 nm was obtained, and the current density when 5 V was applied was 0.93-fold of the current density when 5 V was applied of the light emitting device CD6. The light emission efficiency in emission at 1000 cd/$m^2$ was 18.8 cd/A. The current value was set so that the initial luminance was 3000 cd/$m^2$, then, the device was driven with constant current, and the time change of luminance was measured. The time until the luminance became 95% of the initial luminance was 153.7 hours. The results are shown in Table 7.

[Table 7]

| Light emitting device | Light emitting layer | Annealing treatment | IB/IA | LT95 |
|---|---|---|---|---|
| CD6 | P8 (TG = 148°C) M2 (TG > 148°C) | - | - | 121.1 hours |
| D15 | P8 (TG = 148°C) M2 (TG > 148°C) | 80°C (TA), 60 minutes | 0.93 | 153.7 hours |

<Synthesis Example 1: Synthesis of green phosphorescence emitting iridium complex M1 and red phosphorescence emitting iridium complex M2, and, monomers CM1 to CM16 >

The green phosphorescence emitting iridium complex M1 was synthesized according to a synthesis method described in International Publication WO 2009/131255.

The red phosphorescence emitting iridium complex M2 was synthesized according to a synthesis method described in JP-A No. 2011-105701.

The monomer CM1 was synthesized according to a synthesis method described in JP-A No. 2011-174062.

The monomer CM2 was synthesized according to a method described in International Publication WO 2005/049546.

As the monomer CM3, a commercially available material was used.

The monomer CM4 was synthesized according to a synthesis method described in JP-A No. 2008-106241.

The monomer CM5 was synthesized according to a synthesis method described in JP-A No. 2011-174062.

The monomer CM6 was synthesized according to a synthesis method described in JP-A No. 2012-144722.

The monomer CM7 was synthesized according to a synthesis method described in JP-A No. 2004-143419.

The monomer CM8 was synthesized according to a synthesis method described in JP-A No. 2010-031259.

As the monomer CM9, a commercially available material was used.

The monomer CM10 was synthesized according to a synthesis method described in JP-A No. 2010-189630.

The monomer CM11 was synthesized according to a synthesis method described in International Publication WO 2012/86671.

The monomer CM12 was synthesized according to a synthesis method described in JP-A No. 2010-189630.

The monomer CM13 was synthesized according to a synthesis method described in International Publication WO 2012/86671.

As the monomer CM14, a commercially available compound was used.

The monomer CM15 was synthesized according to a synthesis method described in International Publication WO 2009/131255.

The monomer CM16 was synthesized by the following synthesis method.

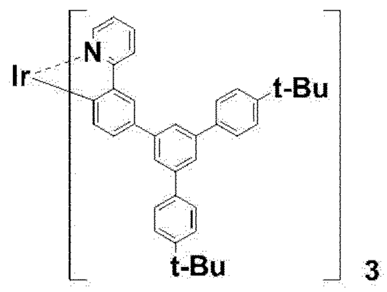

M1

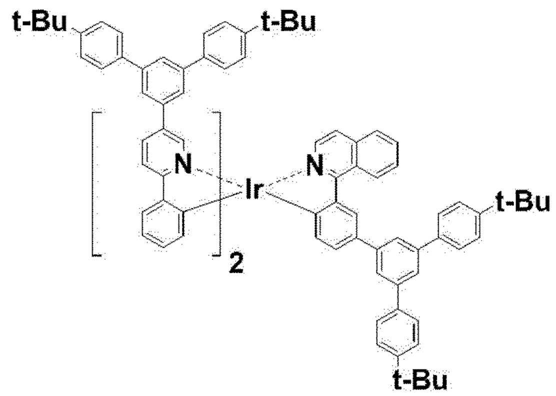

M2

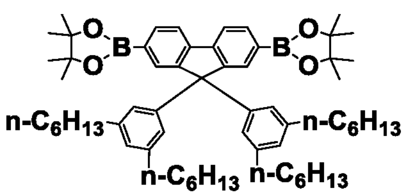

CM1

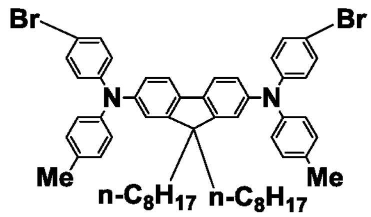

CM2

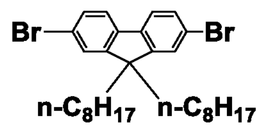

CM3

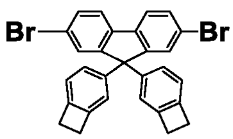

CM4

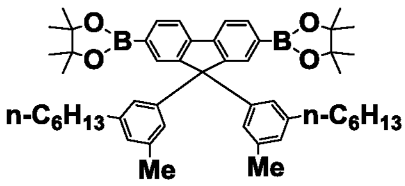

CM5

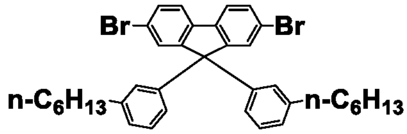

CM6

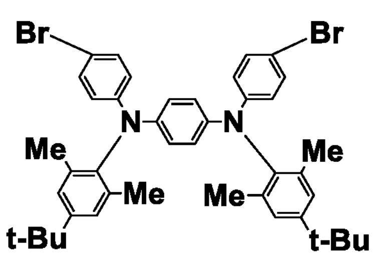

CM7

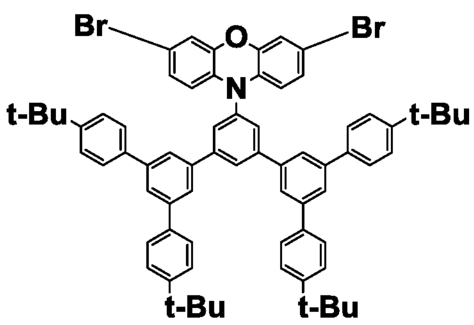

CM8

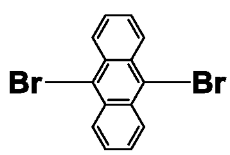

CM9

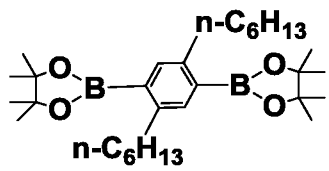

CM10

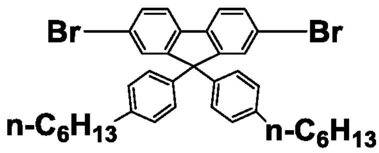

CM11

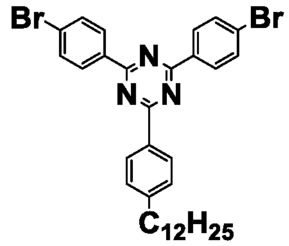

CM12

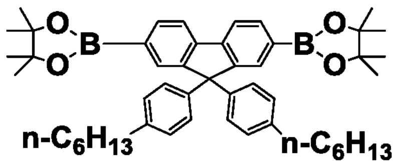

CM13

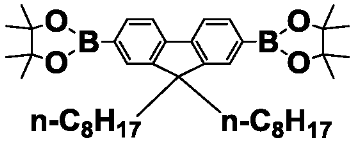

CM14

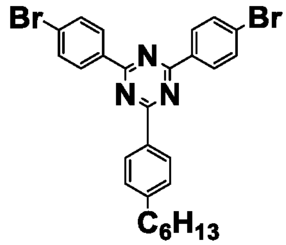

CM15

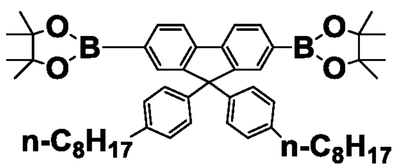

CM16

<Synthesis of monomer CM16>

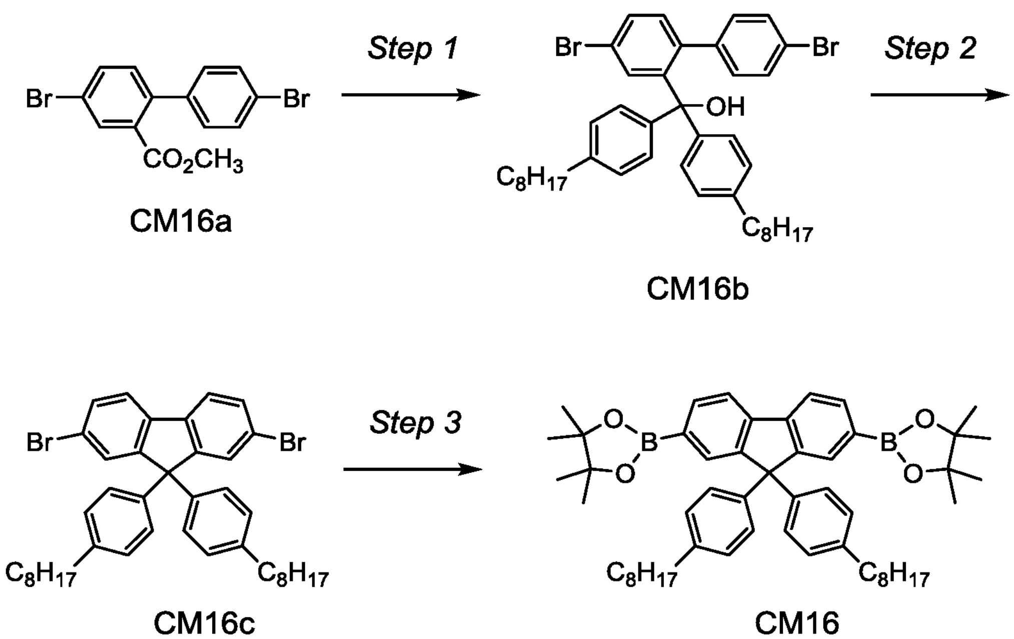


CM16a CM16b CM16c CM16

The compound CM16a was synthesized according to a method described in International Publication WO 2012/086671.

<Step 1>

A nitrogen gas atmosphere was prepared in a reaction vessel, then, 4-bromo-n-octylbenzene (250 g) and tetrahydrofuran (dehydrated product, 2.5 L) were added, and the mixture was cooled down to -70 °C or lower. Into this was dropped a 2.5 mol/L n-butyllithium-hexane solution (355 mL), and the mixture was stirred for 3 hours. Into this was dropped a solution prepared by dissolving the compound CM16a (148 g) in tetrahydrofuran (dehydrated product, 400 mL). After completion of dropping, a cooling bath was removed, and the mixture was stirred at room temperature overnight. The resultant reaction mixture was cooled down to 0°C, water (150 mL) was added and the mixture was stirred. This was concentrated under reduced pressure, to remove an organic solvent. To the resultant reaction mixture were added hexane (1 L) and water (200 mL), and an aqueous layer was removed by liquid separation. The resultant hexane solution was washed with saturated saline, then, dried over magnesium sulfate added. Thereafter, this mixture was filtrated, to obtain a filtrate. This filtrate was concentrated under reduced pressure, to obtain a compound CM16b (330 g) as a yellow oil.

<Step 2>

A nitrogen gas atmosphere was prepared in a reaction vessel, then, the compound CM16b (330 g) and dichloromethane (900 mL) were added, and the mixture was cooled down to 5°C or lower. Into this was dropped a 2.0 mol/L boron trifluoride-diethyl ether complex (245 mL). After completion of dropping, a cooling bath was removed, and the mixture was stirred at room temperature overnight. The reaction mixture was poured into a beaker comprising ice water (2 L) and the mixture was stirred vigorously for 30 minutes, then, an aqueous layer was removed. The resultant organic layer was washed with a 10 wt% potassium phosphate aqueous solution (1 L) once and with water (1 L) twice, then, dried over magnesium sulfate. Thereafter, this mixture was filtrated, and the resultant filtrate was concentrated under reduced pressure. The resultant oil was dissolved in toluene (200 mL), and this was passed through a filter paved with silica gel. Further, the filter was washed with toluene (about 3 L), then, the resultant filtrate was concentrated under reduced pressure. To the resultant oil was added methanol (500 mL) and the mixture was stirred vigorously, then, the reaction mixture was filtrated, to obtain a solid. To this solid was added a butyl acetate/methanol mixed solvent, and recrystallization was repeated, to obtain a compound CM16c (151 g) as a white solid. The compound CM16c had an HPLC area percentage value (detection wavelength: UV 280 nm) of 99.0% or more.
$^1$H-NMR (400 MHz/$CDCl_3$): $\delta$ (ppm) = 7.56 (d, 2H), 7.49 (d, 2H), 7.46 (dd, 2H), 7.06 to 7.01 (m, 8H), 2.55 (t, 4H), 1.61 to 1.54 (m, 4H), 1.30 to 1.26 (m, 20H), 0.87 (t, 6H).

<Step 3>

A nitrogen gas atmosphere was prepared in a reaction vessel, then, the compound CM16c (100 g) and tetrahydrofuran (dehydrated product, 1000 mL) were added, and the mixture was cooled down to -70 °C or lower. Into this was dropped a 2.5 mol/L n-butyllithium-hexane solution (126 mL), and the mixture was stirred for 5 hours. Into this was dropped 2-isopropoxy-4,4,5,5-tetramethyl-1,3,2-dioxaborolane (81 mL). Thereafter, a cooling bath was removed, and the mixture was stirred at room temperature overnight. The reaction mixture was cooled down to -30°C, and a 2.0 M hydrochloric acid-diethyl ether solution (143 mL) was dropped, then, the mixture was heated up to room temperature, and concentrated under reduced pressure, to obtain a solid. To this solid was added toluene (1.2 L), and the mixture was stirred at room temperature for 1 hour, then, passed through a filter paved with silica gel, to obtain a filtrate. This filtrate was concentrated under reduced pressure, to obtain a solid. To this solid was added methanol and the mixture was stirred, then, filtrated, to obtain a solid. This solid was purified by repeating recrystallization using isopropyl alcohol, then, dried under reduced pressure at 50°C overnight, to obtain a compound CM16 (472 g) as a white solid. The compound CM16 had an HPLC area percentage value (detection wavelength: UV 280 nm) of 99.0% or more.
$^1$H-NMR (400 MHz/$CDCl_3$): $\delta$ (ppm) = 7.82 (d, 2H), 7.81 (s, 2H), 7.76 (d, 2H), 7.11 (d, 4H), 7.00 (d, 4H), 2.52 (t, 4H), 1.59 to 1.54 (m, 4H), 1.36 to 1.26 (m, 20H), 1.31 (s, 24H), 0.87 (t, 6H).

<Synthesis Example 2: Synthesis of polymer compounds P9 to P14>

A polymer compound P9 was synthesized by a synthesis method described in JP-A No. 2012-144722 using a monomer mixed composition shown in Table 8. The polymer compound P9 had an Mn of $8.4\times10^4$ and an Mw of $3.4\times10^5$. The polymer compound P9 is a copolymer constituted of constitutional units derived from respective monomers, at a molar ratio shown in Table 8, according to the theoretical values calculated from charged raw materials.
A polymer compound P10 was synthesized by a synthesis method described in JP-A No. 2012-144722 using a monomer mixed composition shown in Table 9. The polymer compound P10 had an Mn of $8.4\times10^4$ and an Mw of $2.3\times10^5$. The polymer compound P10 is a copolymer constituted of constitutional units derived from respective monomers, at a molar ratio shown in Table 9, according to the theoretical values calculated from charged raw materials.

A polymer compound P11 was synthesized by a synthesis method described in JP-A No. 2012-144722 using a monomer mixed composition shown in Table 10. The polymer compound P11 had an Mn of $1.2\times10^5$ and an Mw of $3.1\times10^5$. The polymer compound P11 is a copolymer constituted of constitutional units derived from respective monomers, at a molar ratio shown in Table 10, according to the theoretical values calculated from charged raw materials.

A polymer compound P12 was synthesized by a synthesis method described in JP-A No. 2012-36388 using a monomer mixed composition shown in Table 11. The polymer compound P12 had an Mn of $9.2\times10^4$ and an Mw of $2.3\times10^5$. The polymer compound P12 is a copolymer constituted of constitutional units derived from respective monomers, at a molar ratio shown in Table 11, according to the theoretical values calculated from charged raw materials.

A polymer compound P13 was synthesized by a synthesis method described in International Publication WO 2012-008550 using a monomer mixed composition shown in Table 12. The polymer compound P13 had an Mn of $9.6\times10^4$ and an Mw of $2.4\times10^5$. The polymer compound P13 is a copolymer constituted of constitutional units derived from respective monomers, at a molar ratio shown in Table 12, according to the theoretical values calculated from charged raw materials.

A polymer compound P14 was synthesized by a synthesis method described later.

[Table 8]

| Polymer compound | Monomer mixture composition | | | | |
|---|---|---|---|---|---|
| P9 | Monomer mixture | P9a | | | |
| | Monomer | CM1 | CM2 | CM3 | CM4 |
| | Molar ratio [mol%] | 50 | 30 | 12.5 | 7.5 |

[Table 9]

| Polymer compound | Monomer mixture composition | | | | | |
|---|---|---|---|---|---|---|
| P10 | Monomer mixture | P10a | | | | |
| | Monomer | CM5 | CM6 | CM3 | CM7 | CM8 |
| | Molar ratio [mol%] | 50 | 32 | 10 | 3 | 5 |

[Table 10]

| Polymer compound | Monomer mixture composition | | |
|---|---|---|---|
| P11 | Monomer mixture | P11a | |
| | Monomer | CM1 | CM9 |
| | Molar ratio [mol%] | 50 | 50 |

[Table 11]

| Polymer compound | Monomer mixture composition | | | |
|---|---|---|---|---|
| P12 | Monomer mixture | P12a | | |
| | Monomer | CM10 | CM11 | CM12 |
| | Molar ratio [mol%] | 50 | 40 | 10 |

[Table 12]

| Polymer compound | Monomer mixture composition | | | | | |
|---|---|---|---|---|---|---|
| P13 | Monomer mixture | P13a | | | | |
| | Monomer | CM13 | CM14 | CM6 | CM12 | CM7 |
| | Molar ratio [mol%] | 36 | 14 | 32.5 | 10 | 7.5 |

<Synthesis of polymer compound P14>

An inert gas atmosphere was prepared in a reaction vessel, then, the monomer CM16 (4.7686 g), the monomer CM11 (0.7734 g), the monomer CM3 (1.9744 g), the monomer CM15 (0.3308 g), the monomer CM7 (0.4432 g) and toluene (67 mL) were added, and the mixture was stirred while heating at 105°C. To this was added bistriphenylphosphinepalladium dichloride (4.2 mg), then, a 20 wt% tetraethylammonium hydroxide aqueous solution (20 mL) was added, then, the mixture was stirred under reflux for 3 hours.

To this were added phenylboronic acid (0.077 g), bistriphenylphosphinepalladium dichloride (4.2 mg), toluene (60 mL) and a 20 wt% tetraethylammonium hydroxide aqueous solution (20 mL), and the mixture was stirred under reflux for 24 hours.

The reaction mixture was separated into an organic layer and an aqueous layer, then, to the organic layer were added sodium N,N-diethyldithiocarbamate trihydrate (3.33 g) and ion exchanged water (67 mL), and the mixture was stirred at 85°C for 2 hours. The reaction mixture was separated into an organic layer and an aqueous layer, then, the organic layer was washed with ion exchanged water (78 mL) twice, with a 3 wt% acetic acid aqueous solution (78 mL) twice and with ion exchanged water (78 mL) twice, in this order.

The resultant washing liquid was separated into an organic layer and an aqueous layer, then, the organic layer was dropped into methanol to cause precipitation of a solid which was then isolated by filtration and dried, to obtain a solid. This solid was dissolved in toluene, and the solution was passed through a silica gel column and an alumina column through which toluene had been passed. The resultant toluene solution was dropped into methanol to cause precipitation of a solid which was then isolated by filtration and dried, to obtain a polymer compound P14 (4.95 g). The polymer compound P14 had an Mn of $1.4\times10^5$ and an Mw of $4.1\times10^5$.

The polymer compound P14 is a copolymer constituted of constitutional units derived from respective monomers, at a molar ratio shown in Table 13, according to the theoretical values calculated from charged raw materials.

[Table 13]

| Polymer compound | Monomer mixture composition | | | | | |
|---|---|---|---|---|---|---|
| P14 | Monomer mixture | P14a | | | | |
| | Monomer | CM16 | CM11 | CM15 | CM3 | CM7 |
| | Molar ratio [mol%] | 50 | 10 | 5 | 30 | 5 |

<Comparative Example CD7: Fabrication and evaluation of light emitting device CD7>

On a glass substrate carrying thereon an ITO film with a thickness of 45 nm formed by a sputtering method, a polythiophene•sulfonic acid type hole injection agent AQ-1200 (manufactured by Plectronics) as a hole injection material was spin-coated to form a film with a thickness of 35 nm, and this was heated on a hot plate at 170°C for 15 minutes in an air atmosphere.

Next, a xylene solution of the hole transportable polymer compound P9 (glass transition temperature: 126°C) was spin-coated to form a hole transporting layer with a thickness of 20 nm, and this was heated on a hot plate at 180°C for 60 minutes in a nitrogen gas atmosphere.

Next, a xylene solution of a mixture comprising the blue fluorescence emitting polymer compound P10 (glass transition temperature: 124°C) and the blue fluorescence emitting polymer compound P11 (glass transition temperature: 175°C) at a ratio of 90 wt%:10 wt% was spin-coated to form a light emitting layer with a thickness of 60 nm, and this was heated on a hot plate at 150°C for 10 minutes in a nitrogen gas atmosphere.

Next, sodium fluoride was vapor-deposited with a thickness of about 7 nm as an electron injection layer, then, aluminum was vapor-deposited with a thickness of about 120 nm as a cathode. After the degree of vacuum reached $1\times10^{-4}$ Pa or less, vapor deposition of a metal was initiated.

Next, under a nitrogen gas atmosphere, an encapsulating layer was formed by using a carved glass substrate

having a carved part on which a desiccant HD-071407W-50 (manufactured by Dynic Corporation) had been pasted, to fabricate a light emitting device CD7.

Since the carved glass substrate is used for the formation of the encapsulating layer, a space exists between an anode, a cathode and other layers which a light emitting layer carries and the carved glass substrate. Since the formation of the encapsulating layer is conducted under a nitrogen gas atmosphere, a nitrogen gas is filled in the space.

When voltage was applied to the light emitting device CD7, EL light emission showing a maximum peak at 455 nm was obtained, and the light emission efficiency in emission at 1000 cd/$m^2$ was 9.7 cd/A. The current value was set so that the initial luminance was 1000 cd/$m^2$, then, the device was driven with constant current, and the time change of luminance was measured. The time until the luminance became 95% of the initial luminance was 4.4 hours. The results are shown in Table 14.

<Example D16: Fabrication and evaluation of light emitting device D16>

A light emitting device D16 was fabricated in the same manner as in Comparative Example CD7 excepting that the device was heated at 80°C for 30 minutes on a hot plate in an air atmosphere after the formation of the encapsulating layer, in Comparative Example CD7.

When voltage was applied to the light emitting device D16, EL light emission showing a maximum peak at 455 nm was obtained, and the current density when 5 V was applied was 0.55-fold of the current density when 5 V was applied of the light emitting device CD7. The light emission efficiency in emission at 1000 cd/$m^2$ was 9.4 cd/A. The current value was set so that the initial luminance was 1000 cd/$m^2$, then, the device was driven with constant current, and the time change of luminance was measured. The time until the luminance became 95% of the initial luminance was 5.6 hours. The results are shown in Table 14.

[Table 14]

| Light emitting device | Light emitting layer | Annealing treatment | IB/IA | LT95 |
|---|---|---|---|---|
| CD7 | P10 (TG = 124°C) P11 (TG=175°C) | - | - | 4.4 hours |
| D16 | P10 (TG = 124°C) P11 (TG=175°C) | 80°C (TA), 30 minutes | 0.55 | 5.6 hours |

<Comparative Example CD8: Fabrication and evaluation of light emitting device CD8>

A light emitting device CD8 was fabricated in the same manner as in Comparative Example CD7 excepting that the thickness of the hole injection layer was 65 nm, a composition obtained by mixing the charge transportable polymer compound P12 (glass transition temperature: 102°C) and the green phosphorescence emitting iridium complex M1 (glass transition temperature: 297°C) at a ratio of 70 wt%:30 wt% was used instead of the composition obtained by mixing the blue fluorescence emitting polymer compound P10 and the blue fluorescence emitting polymer compound P11 at a ratio of 90 wt%:10 wt%, and the thickness of the light emitting layer was 80 nm, in Comparative Example CD7.

When voltage was applied to the light emitting device CD8, EL light emission showing a maximum peak at 520 nm was obtained, and the light emission efficiency in emission at 1000 cd/$m^2$ was 57.0 cd/A. The current value was set so that the initial luminance was 3000 cd/$m^2$, then, the device was driven with constant current, and the time change of luminance was measured. The time until the luminance became 95% of the initial luminance was 8.6 hours. The results are shown in Table 15.

<Example D17: Fabrication and evaluation of light emitting device D17>

A light emitting device D17 was fabricated in the same manner as in Comparative Example CD8 excepting that the device was heated at 50°C for 30 minutes on a hot plate in an air atmosphere after the formation of the encapsulating layer, in Comparative Example CD8.

When voltage was applied to the light emitting device D17, EL light emission showing a maximum peak at 520 nm was obtained, and the current density when 5 V was applied was 0.77-fold of the current density when 5 V was applied of the light emitting device CD8. The light emission efficiency in emission at 1000 cd/$m^2$ was 58.1 cd/A. The current value was set so that the initial luminance was 3000 cd/$m^2$, then, the device was driven with constant current, and the time change of luminance was measured. The time until the luminance became 95% of the initial luminance was 15.7 hours. The results are shown in Table 15.

<Example D18: Fabrication and evaluation of light emitting device D18>

A light emitting device D18 was fabricated in the same manner as in Comparative Example CD8 excepting that the device was heated at 60°C for 30 minutes on a hot plate in an air atmosphere after the formation of the encapsulating layer, in Comparative Example CD8.

When voltage was applied to the light emitting device D18, EL light emission showing a maximum peak at 520 nm was obtained, and the current density when 5 V was applied was 0.75-fold of the current density when 5 V was applied of the light emitting device CD8. The light emission efficiency in emission at 1000 cd/$m^2$ was 57.5 cd/A. The current value was set so that the initial luminance was 3000 cd/$m^2$, then, the device was driven with constant current, and the time change of luminance was measured. The time until the luminance became 95% of the initial luminance was 23.3 hours. The results are shown in Table 15.

<Example D19: Fabrication and evaluation of light emitting device D19>

A light emitting device D19 was fabricated in the same manner as in Comparative Example CD8 excepting that the device was heated at 80°C for 30 minutes on a hot plate in an air atmosphere after the formation of the encapsulating layer, in Comparative Example CD8.

When voltage was applied to the light emitting device D19, EL light emission showing a maximum peak at 520 nm was obtained, and the current density when 5 V was applied was 0.62-fold of the current density when 5 V was applied of the light emitting device CD8. The light emission efficiency in emission at 1000 cd/$m^2$ was 56.9 cd/A. The current value was set so that the initial luminance was 3000 cd/$m^2$, then, the device was driven with constant current, and the time change of luminance was measured. The time until the luminance became 95% of the initial luminance was 36.5 hours. The results are shown in Table 15.

[Table 15]

| Light emitting device | Light emitting layer | Annealing treatment | IB/IA | LT95 |
|---|---|---|---|---|
| CD8 | P12 (TG = 102°C) M1 (TG = 297°C) | - | - | 8.6 hours |
| D17 | P12 (TG = 102°C) M1 (TG = 297°C) | 50°C (TA), 30 minutes | 0.77 | 15.7 hours |
| D18 | P12 (TG = 102°C) M1 (TG = 297°C) | 60°C (TA), 30 minutes | 0.75 | 23.3 hours |
| D19 | P12 (TG = 102°C) M1 (TG=297°C) | 80°C (TA), 30 minutes | 0.62 | 36.5 hours |

<Comparative Example CD9: Fabrication and evaluation of light emitting device CD9>

A light emitting device CD9 was fabricated in the same manner as in Comparative Example CD8 excepting that a composition obtained by mixing the charge transportable polymer compound P14 (glass transition temperature: 142°C) and the red phosphorescence emitting iridium complex M2 (glass transition temperature: >148°C) at a ratio of 92.5 wt%:7.5 wt% was used instead of the composition obtained by mixing the charge transportable polymer compound P12 and the green phosphorescence emitting iridium complex M1 at a ratio of 70 wt%:30 wt%, in Comparative Example CD8.

When voltage was applied to the light emitting device CD9, EL light emission showing a maximum peak at 615 nm was obtained, and the light emission efficiency in emission at 1000 cd/$m^2$ was 17.8 cd/A. The current value was set so that the initial luminance was 3000 cd/$m^2$, then, the device was driven with constant current, and the time change of luminance was measured. The time until the luminance became 95% of the initial luminance was 16.1 hours. The results are shown in Table 16.

<Example D20: Fabrication and evaluation of light emitting device D20>

A light emitting device D20 was fabricated in the same manner as in Comparative Example CD9 excepting that the device was heated at 60°C for 30 minutes on a hot plate in an air atmosphere after the formation of the encapsulating layer, in Comparative Example CD9.

When voltage was applied to the light emitting device D20, EL light emission showing a maximum peak at 615 nm was obtained, and the current density when 5 V was applied was 0.92-fold of the current density when 5 V was applied of the light emitting device CD9. The light emission efficiency in emission at 1000 cd/$m^2$ was 17.4 cd/A. The current value was set so that the initial luminance was 3000 cd/$m^2$, then, the device was driven with constant current, and the time change of luminance was measured. The time until the luminance became 95% of the initial luminance

was 28.0 hours. The results are shown in Table 16.

<Example D21: Fabrication and evaluation of light emitting device D21>

A light emitting device D21 was fabricated in the same manner as in Comparative Example CD9 excepting that the device was heated at 80°C for 30 minutes on a hot plate in an air atmosphere after the formation of the encapsulating layer, in Comparative Example CD9.

When voltage was applied to the light emitting device D21, EL light emission showing a maximum peak at 615 nm was obtained, and the current density when 5 V was applied was 0.91-fold of the current density when 5 V was applied of the light emitting device CD9. The light emission efficiency in emission at 1000 cd/$m^2$ was 17.5 cd/A. The current value was set so that the initial luminance was 3000 cd/$m^2$, then, the device was driven with constant current, and the time change of luminance was measured. The time until the luminance became 95% of the initial luminance was 44.4 hours. The results are shown in Table 16.

<Example D22: Fabrication and evaluation of light emitting device D22>

A light emitting device D22 was fabricated in the same manner as in Comparative Example CD9 excepting that the device was heated at 100°C for 30 minutes on a hot plate in an air atmosphere after the formation of the encapsulating layer, in Comparative Example CD9.

When voltage was applied to the light emitting device D22, EL light emission showing a maximum peak at 615 nm was obtained, and the current density when 5 V was applied was 0.81-fold of the current density when 5 V was applied of the light emitting device CD9. The light emission efficiency in emission at 1000 cd/$m^2$ was 17.0 cd/A. The current value was set so that the initial luminance was 3000 cd/$m^2$, then, the device was driven with constant current, and the time change of luminance was measured. The time until the luminance became 95% of the initial luminance was 45.4 hours. The results are shown in Table 16.

[Table 16]

| Light emitting device | Light emitting layer | Annealing treatment | IB/IA | LT95 |
|---|---|---|---|---|
| CD9 | P14 (TG = 142°C) M2 (TG > 148°C) | - | - | 16.1 hours |
| D20 | P14 (TG = 142°C) M2 (TG > 148°C) | 60°C (TA), 30 minutes | 0.92 | 28.0 hours |
| D21 | P14 (TG = 142°C) M2 (TG > 148°C) | 80°C (TA), 30 minutes | 0.91 | 44.4 hours |
| D22 | P14 (TG = 142°C) M2 (TG > 148°C) | 100°C (TA), 30 minutes | 0.81 | 45.4 hours |

<Comparative Example CD11: Fabrication and evaluation of light emitting device CD11>

A light emitting device CD11 was fabricated in the same manner as in Comparative Example CD8 excepting that a toluene solution of a mixture comprising a charge transportable low molecular weight compound (glass transition temperature: 137°C)(trade name: LT-N4013, manufactured by Luminescence Technology) represented by the following formula (HM-1) and the green phosphorescence emitting iridium complex M1 (glass transition temperature: 297°C) at a ratio of 60 wt%:40 wt% was used instead of the xylene solution of the mixture comprising the charge transportable polymer compound P12 and the green phosphorescence emitting iridium complex M1 at a ratio of 70 wt%:30 wt%, in Comparative Example CD8.

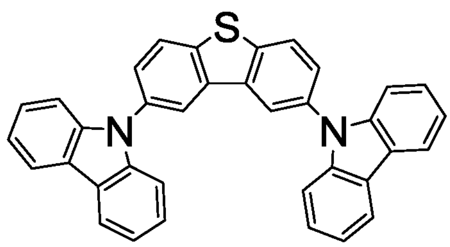

(HM-1)

When voltage was applied to the light emitting device CD11, EL light emission showing a maximum peak at 520 nm was obtained, and the light emission efficiency in emission at 1000 cd/$m^2$ was 24.1 cd/A. The current value was set so that the initial luminance was 3000 cd/$m^2$, then, the device was driven with constant current, and the time change of luminance was measured. The time until the luminance became 95% of the initial luminance was 4.7 hours. The results are shown in Table 17.

<Example D23: Fabrication and evaluation of light emitting device D23>

A light emitting device D23 was fabricated in the same manner as in Comparative Example CD11 excepting that the device was heated at 50°C for 30 minutes on a hot plate in an air atmosphere after the formation of the encapsulating layer, in Comparative Example CD11.

When voltage was applied to the light emitting device D23, EL light emission showing a maximum peak at 525 nm was obtained, and the current density when 5 V was applied was 0.81-fold of the current density when 5 V was applied of the light emitting device CD11. The light emission efficiency in emission at 1000 cd/$m^2$ was 20.0 cd/A. The current value was set so that the initial luminance was 3000 cd/$m^2$, then, the device was driven with constant current, and the time change of luminance was measured. The time until the luminance became 95% of the initial luminance was 5.9 hours. The results are shown in Table 17.

<Example D24: Fabrication and evaluation of light emitting device D24>

A light emitting device D24 was fabricated in the same manner as in Comparative Example CD11 excepting that the device was heated at 80°C for 30 minutes on a hot plate in an air atmosphere after the formation of the encapsulating layer, in Comparative Example CD11.

When voltage was applied to the light emitting device D24, EL light emission showing a maximum peak at 525 nm was obtained, and the current density when 5 V was applied was 0.70-fold of the current density when 5 V was applied of the light emitting device CD11. The light emission efficiency in emission at 1000 cd/$m^2$ was 22.7 cd/A. The current value was set so that the initial luminance was 3000 cd/$m^2$, then, the device was driven with constant current, and the time change of luminance was measured. The time until the luminance became 95% of the initial luminance was 11.5 hours. The results are shown in Table 17.

[Table 17]

| Light emitting device | Light emitting layer | Annealing treatment | IB/IA | LT95 |
|---|---|---|---|---|
| CD11 | HM-1 (TG = 137 °C) M1 (TG = 297°C) | - | - | 4.7 hours |
| D23 | HM-1 (TG = 137 °C) M1 (TG = 297°C) | 50°C (TA), 30 minutes | 0.81 | 5.9 hours |
| D24 | HM-1 (TG = 137 °C) M1 (TG = 297°C) | 80°C (TA), 30 minutes | 0.70 | 11.5 hours |

Industrial Applicability

The present invention can provide a light emitting device excellent in luminance life in the initial period of driving.

## Claims

**1.** A light emitting device comprising
an anode,
a cathode,
a light emitting layer disposed between the anode and the cathode and
an encapsulating layer,
wherein the temperature TA (°C) at which an annealing treatment is conducted after the formation of the encapsulating layer and the glass transition temperature TG (°C) of the material having the lowest glass transition temperature out of all materials each contained in an amount of 1 wt% or more in the light emitting layer satisfy the following formula (1), and
the current density IA at a voltage of 5 V applied before the annealing treatment and the current density IB at a voltage of 5 V applied after the annealing treatment satisfy the following formula (2):

$$TA < TG \quad (1)$$

$$0.50 \times IA \leqq IB \leqq 0.95 \times IA \quad (2).$$

**2.** The light emitting device according to claim 1, wherein the TA and the TG satisfy the following formula (3):

$$TA < TG-30 \quad (3).$$

**3.** The light emitting device according to claim 1 or 2, wherein the TA is 50°C or higher.

**4.** The light emitting device according to claim 3, wherein the TA is 50°C to 80°C.

**5.** The light emitting device according to any one of claims 1 to 4, wherein the IA and the IB satisfy the following formula (4) :

$$0.70 \times IA \leqq IB \leqq 0.90 \times IA \quad (4).$$

**6.** The light emitting device according to any one of claims 1 to 5, wherein the light emitting layer comprises a polymer compound comprising a constitutional unit represented by the following formula (Y):

$$-[Ar^{Y1}]- \quad (Y)$$

wherein $Ar^{Y1}$ represents an arylene group, a divalent heterocyclic group or a divalent group in which at least one arylene group and at least one divalent heterocyclic group are bonded directly to each other, and these groups each optionally have a substituent.

**7.** The light emitting device according to claim 6, wherein the light emitting layer further comprises a triplet light emission complex.

**INTERNATIONAL SEARCH REPORT**

International application No.
PCT/JP2014/075765

A. CLASSIFICATION OF SUBJECT MATTER
*H05B33/10*(2006.01)i, *C08G61/12*(2006.01)i, *H01L51/50*(2006.01)i, *H05B33/04*(2006.01)i

According to International Patent Classification (IPC) or to both national classification and IPC

B. FIELDS SEARCHED

Minimum documentation searched (classification system followed by classification symbols)
H05B33/10, C08G61/12, H01L51/50, H05B33/04

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2014 |
| Kokai Jitsuyo Shinan Koho | 1971-2014 | Toroku Jitsuyo Shinan Koho | 1994-2014 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>Y | JP 2000-311784 A (Toyota Central Research and Development Laboratories, Inc.), 07 November 2000 (07.11.2000), paragraph [0010] to [0011], [0033] to [0039], [0044] to [0046]; fig. 1 to 2, 10 to 11 (Family: none) | 1-5<br>1-7 |
| Y | WO 2013/027656 A1 (Sumitomo Chemical Co., Ltd.), 28 February 2013 (28.02.2013), page 27, line 6 to page 48, line 9; page 88, lines 23 to 25; page 130, line 10 to page 131, line 5 & JP 2013-60585 A & US 2014/0183414 A | 1-7 |

☒ Further documents are listed in the continuation of Box C.  ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 19 November, 2014 (19.11.14) | 02 December, 2014 (02.12.14) |

| Name and mailing address of the ISA/ | Authorized officer |
|---|---|
| Japanese Patent Office | |
| Facsimile No. | Telephone No. |

Form PCT/ISA/210 (second sheet) (July 2009)

**INTERNATIONAL SEARCH REPORT**

International application No.
PCT/JP2014/075765

C (Continuation). DOCUMENTS CONSIDERED TO BE RELEVANT

| Category* | Citation of document, with indication, where appropriate, of the relevant passages | Relevant to claim No. |
|---|---|---|
| Y | WO 2013/031638 A1 (Sumitomo Chemical Co., Ltd.), 07 March 2013 (07.03.2013), paragraphs [0083] to [0111], [0128] to [0139], [0198], [0214], [0218] & JP 2013-49806 A & US 2014/0191160 A & TW 201319142 A | 1-7 |
| A | JP 2002-246183 A (Semiconductor Energy Laboratory Co., Ltd.), 30 August 2002 (30.08.2002), entire text; all drawings & JP 2005-101015 A & US 2002/0084464 A1 & US 2004/0075112 A1 | 1-7 |

Form PCT/ISA/210 (continuation of second sheet) (July 2009)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- US 20060040136 A
- WO 2009131255 A
- JP 2011105701 A
- JP 2011174062 A
- WO 2005049546 A
- JP 2008106241 A
- JP 2012144722 A
- JP 2004143419 A
- JP 2010031259 A
- JP 2010189630 A
- WO 201286671 A
- WO 2012086671 A
- JP 2012036388 A
- WO 2012008550 A